# EUROPEAN PATENT APPLICATION

(11) **EP 4 580 338 A1**
(43) Date of publication of application: **02.07.2025**
(21) Application number: 24208309.5
(22) Date of filing: 23.10.2024
(51) Int. Cl.: H10D 62/10, H10D 30/01, H10D 30/43, H10D 30/00, H10D 84/01, H10D 84/03, H10D 84/83

(54) **FRONT SIDE AND BACKSIDE SOURCE OR DRAIN CONTACTS**

(30) Priority: 29.12.2023 US 202318400472
(71) Applicant: Intel Corporation, Santa Clara, CA 95054 (US)
(72) Inventor: Mannebach, Ehren, Beaverton, 97007 (US); Mills, Shaun, Hillsboro, 97124 (US); Silva, Joseph, Hillsboro, 97124 (US); Kobrinsky, Mauro, Portland, 97229 (US); Desai, Umang, Portland, 97225 (US); Guler, Leonard, Hillsboro, 97124 (US); Mahajan, Kalpesh, Portland, 97229 (US); Panella, Jessica, Banks, 97106 (US); Vishwakarma, Vivek, Portland, 97223 (US); Unluer, Dincer, Hillsboro, 97123 (US); Wadekar, Shardul, Hillsboro, 97123 (US)
(74) Representative: Goddar, Heinz J.

(57) **Abstract**

An integrated circuit structure includes a device layer including a plurality of devices. The plurality of devices includes (i) a plurality of source and drain regions, (ii) a plurality of gate stacks, and (iii) a plurality of gate spacers, each gate spacer separating a corresponding source or drain region from a corresponding gate stack, the gate spacers comprising a first dielectric material. A first source or drain contact is coupled to a frontside of a first source or drain region of the plurality of source or drain regions. A second dielectric material is coupled to a backside of the first source or drain region. A second source or drain contact is coupled to a backside of a second source or drain region of the plurality of source or drain regions. In an example, the first dielectric material and the second dielectric material comprise the same elemental constituents.

## Description

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device; and in instances where the charge carriers are holes, the FET is referred to as a p-channel device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A gate-all-around (GAA) transistor is configured similarly to a fin-based transistor, but instead of a finned channel region, one or more channel bodies such as nanoribbons or nanowires extend between the source and the drain regions. In GAA transistors, the gate material wraps around each such body.

Scaling of integrated circuit structures, including GAA transistor devices or other types of transistor devices, results in high density of scaled interconnect features. One approach to circumvent congestion of frontside interconnects due to power and signal routing includes the use of a backside power and/or signal delivery. However, there remain a number of non-trivial challenges with respect to scaled interconnects.

### BRIEF DESCRIPTION OF THE DRAWINGS

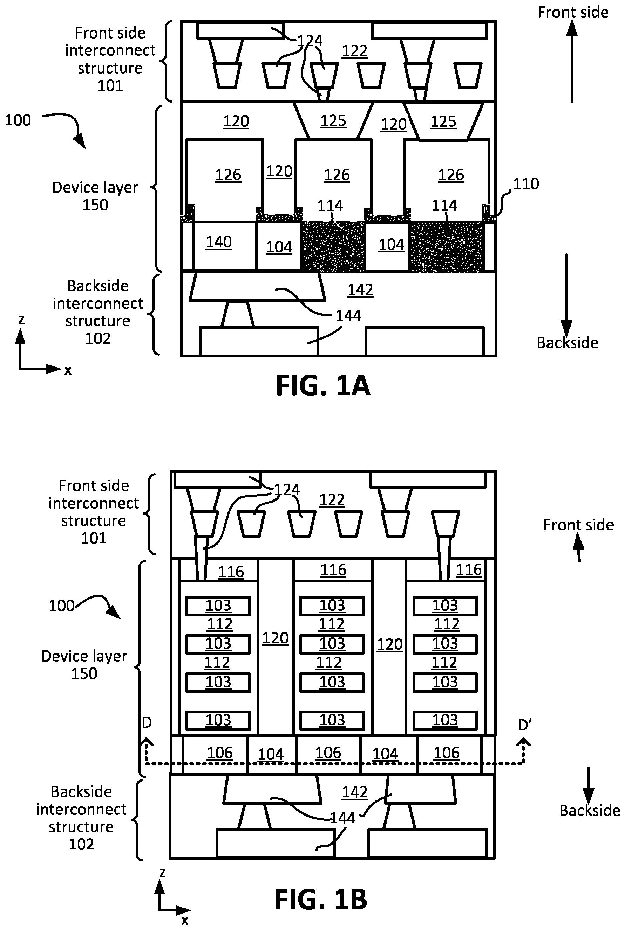

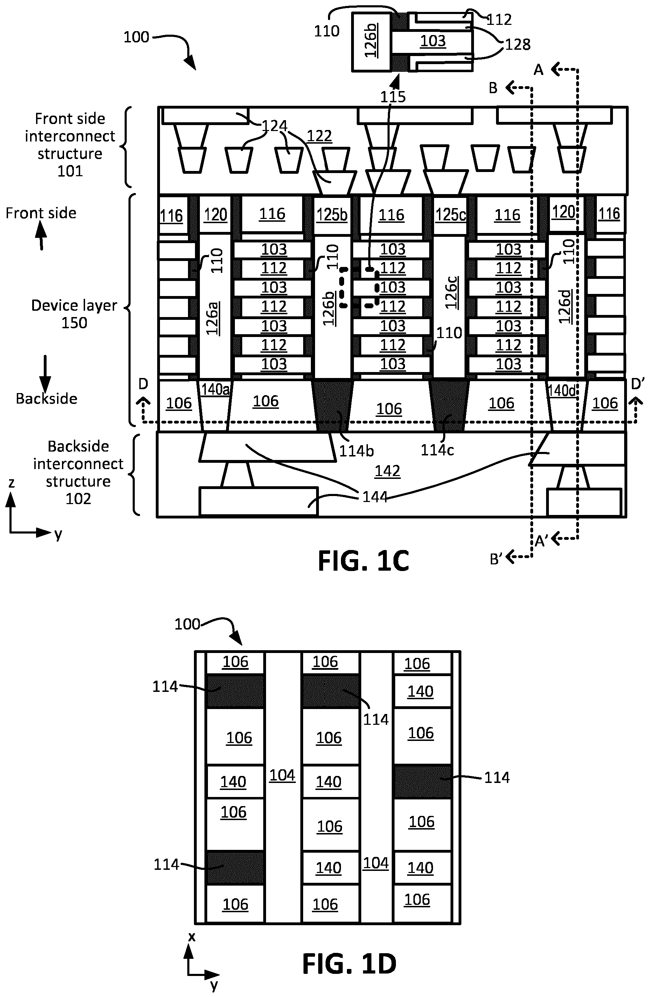

Figs. 1A, 1B, 1C, and 1D illustrate various views of an integrated circuit structure comprising a device layer including a plurality of integrated circuit devices, each device including (i) source and drain regions, (ii) a channel region including one or more bodies comprising semiconductor material extending laterally between corresponding source and drain regions, (iii) a gate stack comprising a gate electrode wrapped at least in part around the one or more bodies, and (iv) a gate spacer laterally between and separating a corresponding a source or drain region and a corresponding gate electrode, wherein the gate spacer comprises a first dielectric material, wherein a first source or drain contact is coupled to a frontside of a first source or drain region of the device layer, wherein a layer comprising a second dielectric material is coupled to a backside of the first source or drain region, wherein a second source or drain contact coupled to a backside of a second source or drain region of the device layer, and wherein the first dielectric material of the gate spacer and the second dielectric material of the layer are the same dielectric material (e.g., elementally the same, and may also compositionally be the same), in accordance with an embodiment of the present disclosure.

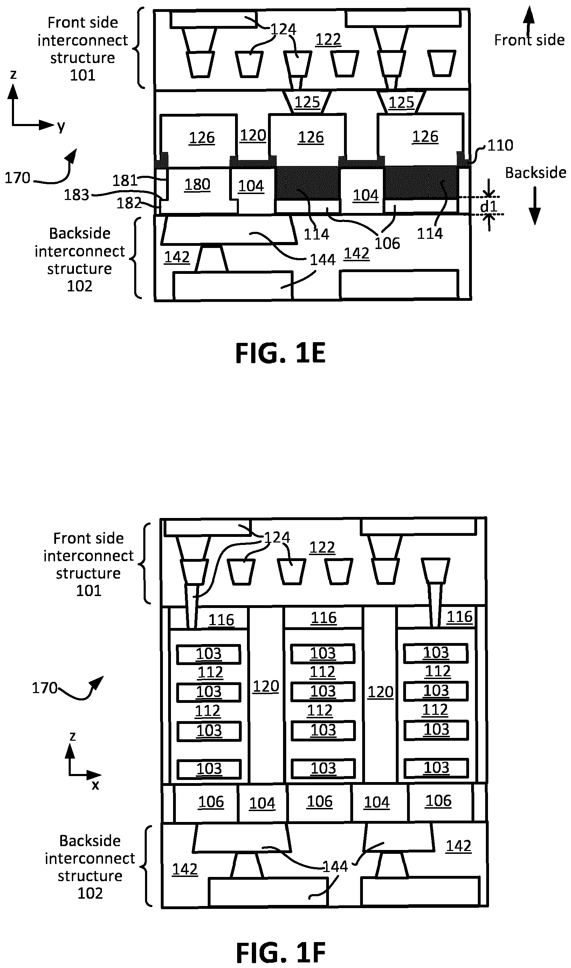

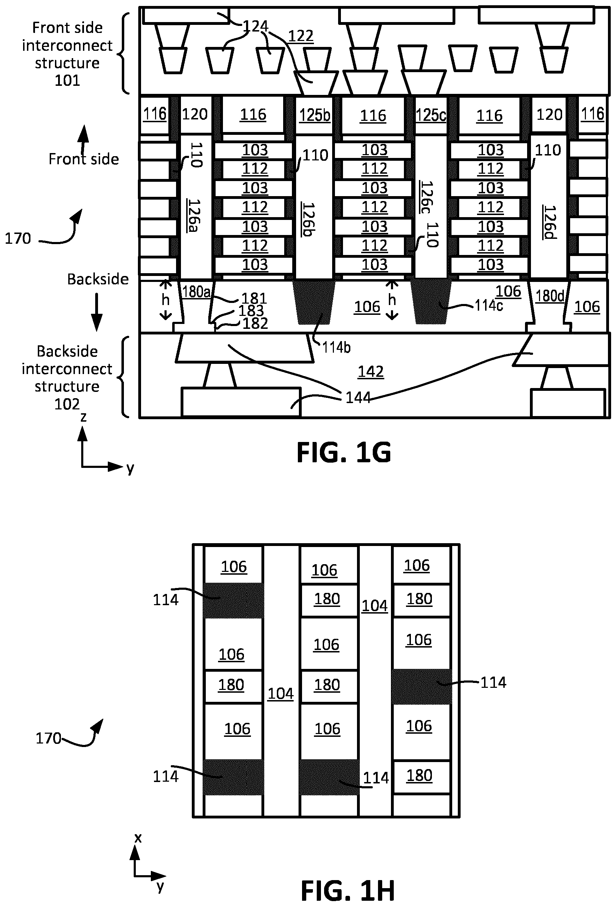

Figs. 1E, 1F, 1G, and 1H illustrate various views of another integrated circuit structure that is at least in part similar to the integrated circuit structure of Figs. 1A-1D, wherein in the integrated circuit structure of Figs. 1E-1H, a backside source or drain contact has a stepped sidewall, in accordance with an embodiment of the present disclosure.

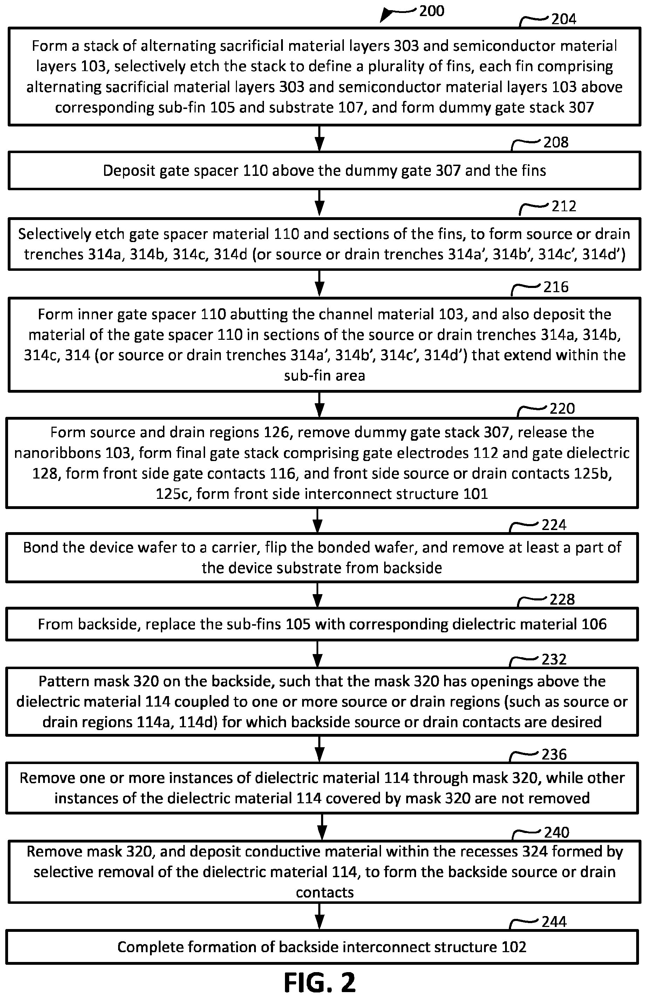

Fig. 2 illustrates a flowchart depicting a method of forming the example integrated circuit structures of Figs. 1A-1H, in accordance with an embodiment of the present disclosure.

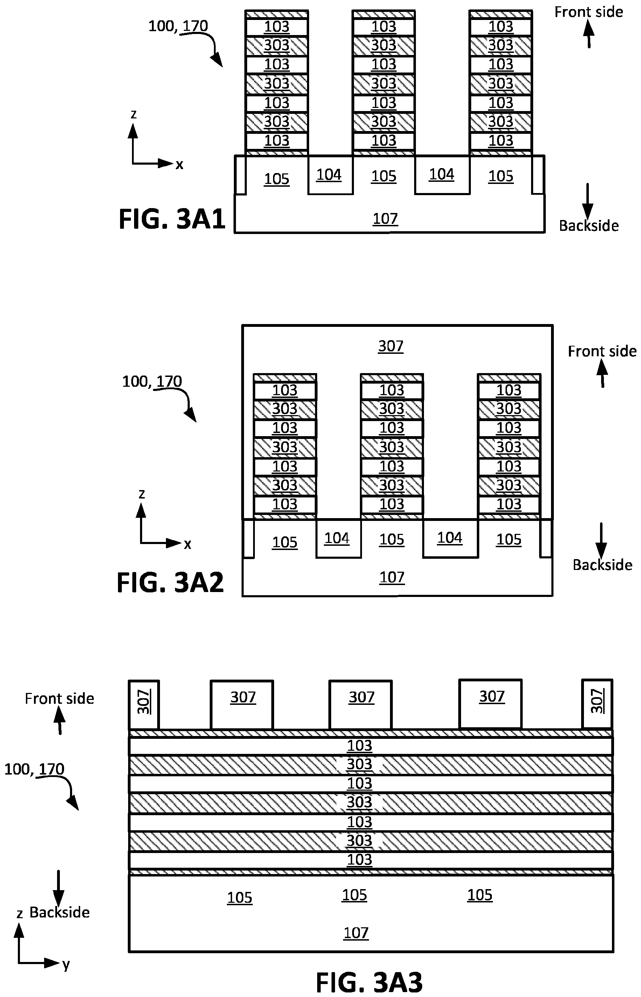

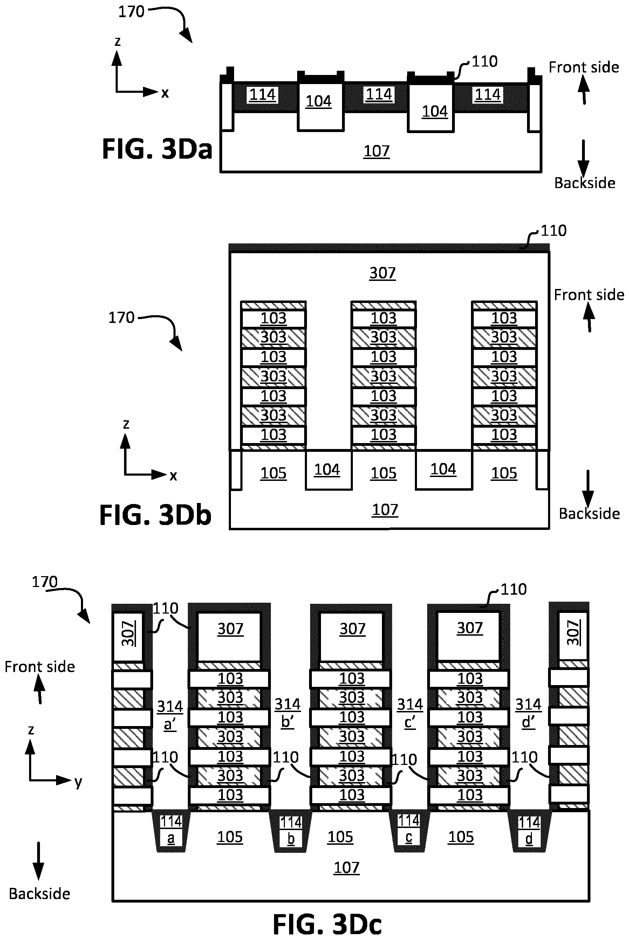

Figs. 3A1, 3A2, 3A3, 3B1, 3B2, 3B3, 3C1, 3C2, 3C3, 3Ca, 3Cb, 3Cc, 3D1, 3D2, 3D3, 3Da, 3Db, 3Dc, 3E1, 3E2, 3E3, 3Ea, 3Eb, 3Ec, 3F1, 3F2, 3F3, 3F4, 3Fa, 3Fb, 3Fc, 3Fd, 3G1, 3G2, 3G3, 3G4, 3Ga, 3Gb, 3Gc, 3Gd, 3H1, 3H2, 3H3, 3H4, 3Ha, 3Hb, 3Hc, 3Hd, 3I1, 3I2, 3I3, 3I4, 3Ia, 3Ib, 3Ic, 3Id, 3Ie, 3If, 3Ig, 3Ih, 3J1, 3J2, 3J3, 3J4, 3Ja, 3Jb, 3Jc, 3Jd, 3K1, 3K2, 3K3, 3K4, 3Ka, 3Kb, 3Kc, and 3Kd collectively illustrate cross-sectional views of example integrated circuit structures in various stages of processing in accordance with the methodology of Fig. 2, in accordance with an embodiment of the present disclosure.

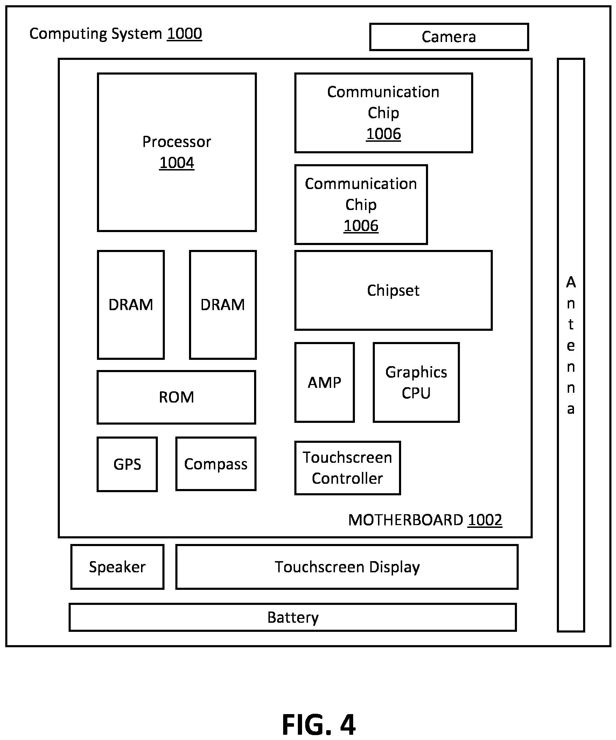

Fig. 4 illustrates a computing system implemented with integrated circuit structures formed using the techniques disclosed herein, in accordance with some embodiments of the present disclosure.

As will be appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used. Likewise, while the thickness of a given first layer may appear to be similar in thickness to a second layer, in actuality that first layer may be thinner or thicker than the second layer; same goes for other layer or feature dimensions.

### DETAILED DESCRIPTION

Microelectronic device structures including both frontside source or drain contacts, and backside source or drain contacts, and techniques for forming such frontside and backside source or drain contacts, are provided herein. The techniques are particularly useful in gate-all-around (GAA) transistor architectures such as nanowire and nanoribbon transistors, although they may also benefit other transistor topologies such as forksheet transistors or other transistors having epitaxial source and drain regions. Beneficially, trenches for backside source or drain contacts are formed from the frontside during source and drain processing, and sacrificial dielectric material is deposited within the trenches (e.g., within lower portions of the trenches, such as portions of the trenches extending within the sub-fin regions) from the frontside, e.g., during gate spacer deposition process. In an example, the sacrificial dielectric material and the gate spacer material comprise the same elemental constituents, and are elementally (and may also be compositionally) the same, as the sacrificial dielectric material is deposited during the gate spacer formation process. Subsequently, epitaxial (epi) source or drain regions are formed within the trenches and above the sacrificial dielectric material. Subsequently, if a backside source or drain contact is desired for a given source or drain region, the sacrificial material coupled to the given source or drain region is removed from the backside, and replaced with conductive material. On the other hand, if a given source or drain region has a frontside source or drain contact, the sacrificial material coupled to the backside of the second source or drain region is left in place. Thus, a given source or drain region may have a source or drain contact at its backside, or has dielectric material at its backside, where the dielectric material is elementally (and also may be compositionally) the same as the gate spacer material. In an example, the dielectric material and the gate spacer material comprise the same elemental constituents. Numerous configurations and variations will be apparent in light of this disclosure.

### General Overview

As noted above, there remain a number of non-trivial challenges with respect to scaled interconnects. For example, in addition to a frontside interconnect structure, a backside interconnect structure alleviates congestion and scaling issues with the frontside interconnect structure. To facilitate a backside interconnect structure, a source or drain region can have a frontside source or drain contact, or backside source or drain contact. However, processes to form backside source or drain contacts can damage or erode surrounding materials, such as a gate stack and/or a gate spacer, thereby impacting yield and performance.

Accordingly, techniques are provided herein to form an integrated circuit structure that includes first one or more source or drain regions having one or more backside source or drain contacts, and second one or more source or drain regions having one or more frontside source or drain contacts. Advantageously, trenches for backside source or drain contacts are formed from the frontside, and sacrificial dielectric material is deposited within the trenches (e.g., within lower portions of the trenches, such as portions of the trenches extending within the sub-fin regions) from the frontside, e.g., during gate spacer deposition process. Subsequently, epi source and drain regions are formed within the trenches and above the sacrificial dielectric material. Subsequently, if a backside source or drain contact is desired for a first source or drain region, the sacrificial material coupled to the first source or drain region is removed from the backside, and replaced with conductive material. The first source or drain contact is, thus, self-aligned to the first source or drain region. Additionally, the trench for the first source or drain contact is formed from the frontside, and the sacrificial dielectric material is also deposited from the frontside during the gate spacer deposition process, without causing any damage, or reduced damage, to surrounding material, thereby improving yield and performance.

In further detail, in one embodiment, during the source or drain trench formation process, the source or drain trench is extended deeper, e.g., within the sub-fin regions of the devices. Lower portions of the trenches are filled with dielectric material, e.g., when the gate spacers (also referred to as inner gate spacers, or cavity spacers) are formed. Accordingly, the dielectric material filling the lower portions of the trenches is the same as the gate spacer dielectric material (they are deposited during the same dielectric material deposition process). At least portions of the dielectric material occupying the lower portions of at least some of the trenches are later removed and replaced with conductive material to form backside source or drain contacts, and hence, the dielectric material occupying the lower portions of the trenches is referred as sacrificial dielectric material. Note, however, that in some instances, the sacrificial dielectric material may be left intact within the final integrated circuit structure.

After deposition of the sacrificial dielectric material within the trenches, further processing may commence, such as formation of source or drain regions, releasing of the nanoribbons (or other GAA channel configurations, such as nanowires or nanosheets), formation of the final replacement gate stack, and formation of a frontside interconnect structure. Note that each source or drain region is self-aligned with the corresponding sacrificial dielectric material at the bottom of the source or drain trench and below the source or drain region. In an example, one or more source or drain regions have frontside source or drain contacts coupled to the frontside interconnect structure.

Subsequently, the frontside of the wafer is bonded to a carrier wafer, so as to allow for access to the backside of the wafer. From the backside, the substrate is removed, and at least a portion of the sub-fin regions are removed and replaced with dielectric material. In one example, during the substrate removal process, if the prior formed source or drain trenches are deep enough (e.g., extend fully though the sub-fin regions), the sacrificial dielectric material within the trenches is exposed from the backside. In another example, during the substrate removal process, if the prior formed source or drain trenches are not deep enough (e.g., do not extend fully though the sub-fin regions), the sacrificial dielectric material is not exposed from the backside, and is still covered by a dielectric material used to replace the sub-fin regions.

Subsequently, a mask is patterned on the backside, where the mask has one or more openings above corresponding the sacrificial dielectric material, which is to be replaced with conductive materials, to form corresponding backside source or drain contacts. The mask may cover one or more other locations of the sacrificial material, with those location being coupled to source or drain regions having frontside source or drain contacts. For example, assume that the mask has an opening above a first sacrificial material coupled to a first source or drain region, and doesn't have an opening above a second sacrificial material coupled to a second source or drain region (where the second source or drain region may have a frontside source or drain contact). The first sacrificial material is removed from the backside through the opening within the mask, and subsequently replaced with a conductive material, to form a backside source or drain contact for the first source or drain region. On the other hand, the second sacrificial material coupled to the second source or drain region is not removed, because it is covered by the mask.

In an example in which the prior formed source or drain trenches are etched together and deep enough (e.g., are exposed through the backside during substrate removal), the backside surfaces of the backside source or drain contact for the first source or drain region and the second sacrificial material are substantially coplanar, such as within a tolerance of at most 5 nm, or at most 3 nm, or at most 2 nm, or at most 1 nm, for example, as will be described below. Some variances in trench depth may occur, due to factors such as the trench geometries and loading (similarly shaped and spaced trenches will tend to etch similarly, whereas differently shaped and spaced trenches may etch at different rates and thus have more divergent trench depths).

In another example in which the prior formed source or drain trenches are not deep enough (e.g., are not exposed through the backside during substrate removal), the opening within the mask doesn't reveal the first sacrificial material (e.g., for being covered by the dielectric material that is used to replace the sub-fin regions). In such an example, the first sacrificial material replacement is performed using two removal processes through the opening within the mask: (i) a first removal process that removes the dielectric material covering the first sacrificial material, and (ii) a second removal process that removes the first sacrificial material. This results in a recess on the backside of the first source or drain region, where the recess has a stepped sidewall (e.g., see Figs. 1E and 1G). Consequently, the backside source or drain contact formed within the recess also has a corresponding stepped sidewall. Numerous configurations and variations will be apparent in light of this disclosure.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAIAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material. If two materials are elementally the same, then the two materials comprise the same elemental constituents.

Use of the techniques and structures provided herein may be detectable using tools such as electron microscopy including scanning/transmission electron microscopy (SEM/TEM), TEM electron energy loss spectroscopy (TEM-EELS), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography (APT); local electrode atom probe (LEAP) techniques; 3D tomography; or high resolution physical or chemical analysis, to name a few suitable example analytical tools. For example, such tools may be used to detect an integrated circuit structure including a device layer having some source and/or drain regions contacted with frontside contacts, and some source or drain regions contacted by backside contacts, wherein source/drain recesses extend into the subfin region even in non-backside contact regions where the recesses have their bottoms filled with dielectric material that is also used for the internal gate spacers. Moreover, if a given backside contact has its critical expanded, TEM-EELS, APT or SIMs may show etchant species next to the backside contact. Numerous configurations and variations will be apparent in light of this disclosure.

### Architecture

Figs. 1A, 1B, 1C, and 1D illustrate various views of an integrated circuit structure 100 (also referred to herein as "structure 100") comprising a device layer 150 including a plurality of integrated circuit devices (such as GAA devices), each device including (i) one or more source or drain regions 126, (ii) a channel region including one or more bodies 103 comprising semiconductor material extending laterally between two corresponding source or drain regions, (iii) a gate stack comprising a gate electrode 112 wrapped at least in part around the one or more bodies, and (iv) a gate spacer 110 laterally between and separating a corresponding a source or drain region 126 and a corresponding gate electrode 112, wherein the gate spacer 110 comprises a first dielectric material, wherein a first source or drain contact 125b is coupled to a frontside of a first source or drain region 126b of the device layer 104, wherein a layer 114b comprising a second dielectric material is coupled to a backside of the first source or drain region 126b, wherein a second source or drain contact 140a coupled to a backside of a second source or drain region 126a of the device layer 150, and wherein the first dielectric material of the gate spacer 110 and the second dielectric material of the layer 114b are elementally and/or compositionally same, in accordance with an embodiment of the present disclosure. In an example, the first dielectric material of the gate spacer 110 and the second dielectric material of the layer 114b comprise the same elemental constituents.

The cross-section view of Fig. 1A is taken parallel to, and through, the source or drain regions. The cross-section view of Fig. 1A is a channel-cut view centered on the source or drain regions, and accordingly, the gate stack is not illustrated in Fig. 1A. The cross-section view of Fig. 1B is taken parallel to, and through, the gate stack. The cross-section view of Fig. 1B is a channel-cut view centered on the gate stack. Accordingly, the source or drain regions are not illustrated in Fig. 1B. The cross-section view of Fig. 1C is taken parallel to, and through, the fin structure (e.g., by cutting through the gate stack), such that the channel, source, and drain regions are shown. Thus, the cross-section view of Fig. 1C is a gate-cut view centered on the channel regions. The cross-section view of Fig. 1A is along line A-A' of Fig. 1C. The cross-section view of Fig. 1B is along line B-B' of Fig. 1C. Also, Fig. 1D is a plan view of the structure 100, when viewed from the backside of the structure 100, e.g., along lines D-D' of Figs. 1B and 1C.

The devices within the device layer 150 are arranged in an array including a plurality of laterally adjacent devices. Accordingly, the devices, including the source or drain regions of the devices illustrated in Fig. 1A does not necessarily match with the devices, including the source or drain regions of the devices illustrated in Figs. 1B and/or 1C. Note that Figs. 1A and 1B are along the X-Z plane, while Fig. 1C is along the Y-Z plane.

As illustrated in Figs. 1A-1C, the structure 100 includes the device layer 150 comprising a plurality of devices, such as GAA devices. In the orientation of the structure 100 illustrated in Figs. 1A-1C, a section of the structure 100 above the device layer 150 is referred to as a frontside of the device layer 150, and another section of the structure 100 below the device layer 150 is referred to herein as a backside of the of the device layer 150. The frontside and backside are symbolically illustrated in Figs. 1A-1C using respective arrows. In an example, the frontside and the backside are respectively the front and backsides of individual transistor devices within the device layer 150.

As illustrated in Figs. 1A-1C, the structure 100 comprises a frontside interconnect structure 101 on the frontside (or above, in the orientations of Figs. 1A-1C) of the device layer 150. As also illustrated in Figs. 1A-1C, the structure 100 comprises a backside interconnect structure 102 on the backside (or below, in the orientations of Figs. 1A-1C) of the device layer 150.

The frontside interconnect structure 101 comprises various back end of line (BEOL) metallization layers, such as a plurality of conductive interconnect features 124 within one or more layers 122 of dielectric material. Various such layers 122 of dielectric material may be separated by corresponding etch stop layers, although the etch stop layers are not illustrated in Figs. 1A-1C. The conductive interconnect features 124 may be conductive lines and/or conductive vias, in an example.

Similarly, the backside interconnect structure 102 comprises various backside metallization layers, such as a plurality of conductive interconnect features 144 within one or more layers 142 of dielectric material. Various such layers 142 of dielectric material may be separated by corresponding etch stop layers, although the etch stop layers are not illustrated in Figs. 1A-1C. The conductive interconnect features 144 may be conductive lines and/or conductive vias, in an example.

In an example, one or more of the devices included in the device layer 150 of the structure 100 each includes a corresponding channel layer comprising one or more bodies 103, where the one or more bodies comprise semiconductor material. The semiconductor bodies 103 included in the channel regions of the devices can vary in form, and in some examples described herein are in the form of nanoribbons. In particular, the channel region of each depicted devices in this example case includes a vertical stack of four nanoribbons 103 (see Figs. 1B and 1C). Other examples may include fewer nanoribbons per channel region (e.g., one, two, or three), or more nanoribbons per channel region (e.g., five or six). Still other embodiments may include other channel configurations, such as one or more nanowires or nanosheets or other semiconductor bodies. To this end, the present disclosure is not intended to be limited to any particular channel configuration or topology; rather the techniques provided herein can be used in any transistor architecture that uses complementary type of adjacent transistors. In an example, the devices of the device layer 150 may also include stacked transistor devices, where, for example, an NMOS transistor device is stacked atop a PMOS transistor device, and this stacking is repeated laterally, to form a plurality of laterally adjacent stacked device pairs.

Each device includes one or more source or drain regions 126. For ease of identification, in Fig. 1C, the four illustrated source or drain regions are specifically labelled as 126a, 126b, 126c, 126d. The source or drain regions illustrated in Fig. 1A are generally labelled as source or drain regions 126. A source or drain region may be configured as a source region, or as a drain region. Note that in an example, the location of a source region and a drain region in a device may be interchanged, and hence, these regions are generally referred to as source or drain regions. Each device may include a corresponding source region and a drain region. In the devices of the device layer 150 of the structure 100, each of the source or drain regions 126 is adj acent to a gated channel region on either side. Other embodiments may not have gated channel regions to each side of a source or drain region.

The source and drain regions 126 can be any suitable semiconductor material and may include any dopant scheme. In an example, source or drain regions of a PMOS device can be PMOS source or drain regions that include, for example, group IV semiconductor materials such as silicon, germanium, SiGe, germanium tin (GeSn), SiGe alloyed with carbon (SiGe:C). Example p-type dopants include boron, gallium, indium, and aluminum. In an example, source or drain regions of a NMOS device can be NMOS source and drain regions that include, for example, silicon or group III-V semiconductor materials such as two or more of indium, aluminum, arsenic, phosphorus, gallium, and antimony, with some example compounds including but not limited to indium aluminum arsenide, indium arsenide phosphide, indium gallium arsenide, indium gallium arsenide phosphide, gallium antimonide, gallium aluminum antimonide, indium gallium antimonide, or indium gallium phosphide antimonide. In one specific embodiment, PMOS source and drain regions are boron-doped SiGe, and NMOS source and drain regions are phosphorus-doped silicon. In a more general sense, the source and drain regions can be any semiconductor material suitable for a given application.

In some cases, individual portions of an epitaxially formed source or drain region (also referred to as epi source or drain region) described above may include a multilayer structure, such as a germanium cap on a SiGe body, or a germanium body and a carbon-containing SiGe spacer or liner between the corresponding channel region and that germanium body. In any such cases, a portion of the epi source and drain regions may have a component that is graded in concentration, such as a graded germanium concentration to facilitate lattice matching, or a graded dopant concentration to facilitate low contact resistance. Any number of source and drain configurations can be used as will be appreciated, and the present disclosure is not intended to be limited to any particular such configurations.

Adjacent source or drain regions 126 (e.g., adjacent along the X axis direction of Figs. 1A-1D) are separated from each other by a layer 120 comprising dielectric material, such as an interlayer dielectric material (ILD), as illustrated in Fig. 1A. The layer 120 is also between adjacent gate stacks comprising gate electrodes 112 of adjacent devices, as illustrated in Fig. 1B. The dielectric material of the layer 120 may comprise an appropriate nitride, oxide, carbide, oxycarbide, oxynitride, and/or oxycarbonitride, and/or may (or may not) include silicon, for example, although any other appropriate dielectric material may also be used.

Each source or drain region 126 has a corresponding source or drain contact (although in one example, a source or drain region may not have a corresponding source or drain contact, such as an example case where the source or drain region is not contacted). A source or drain contact for a given source or drain region may be from a frontside of the source or drain region 126 or a backside of the source or drain region, which are respectively referred to as a frontside source or drain contact, or a backside source or drain contact.

In one example, the structure 100 may have backside power and/or signal routing (such as backside power routing) using backside interconnect structure 102, as well as frontside power and/or signal routing (such as frontside signal routing) using frontside interconnect structure 101. In such an example, power to one or more devices of the device layer 150 may be delivered using backside source or drain contacts, and signals may be routed using frontside source or drain contacts. In such an example, one or more source regions may have corresponding backside source contacts for receiving power (as source region of a device may receive power), whereas one or more drain regions may have corresponding frontside drain contacts for routing signals, although the location of a source region and a drain region and positions of source or drain contacts thereof in a device may be interchanged.

Fig. 1A illustrates three example source or drain regions 126, where two right source or drain regions have source or drain contacts 125 from a frontside of the source or drain regions (e.g., have frontside source or drain contacts), and a left source or drain region has a source or drain contact 140 from a backside of the source or drain region (e.g., has a backside source or drain contact).

Fig. 1C illustrates four source or drain regions 126a, 126b, 126c, 126d. The source or drain regions 126a and 126d have backside source or drain contacts 140a and 140d, respectively. The source or drain regions 126b and 126c have frontside source or drain contacts 125b and 125c, respectively. Thus, two adjacent source or drain regions 126a and 126b of a device of the device layer 150 have respectively a backside source or drain contact 140a and a frontside source or drain contact 125b, as illustrated in Fig. 1C.

Because the source or drain regions 126a and 126d have backside source or drain contacts 140a and 140d, the frontside of the source or drain regions 126a and 126d do not have any corresponding source or drain contacts. Accordingly, the frontside of the source or drain regions 126a and 126d are also covered with the above described layer 120 of dielectric material, as illustrated in Fig. 1C.

In one embodiment, the source or drain regions 126 that have frontside source or drain contacts (such as source or drain regions 126b, 126c having frontside source or drain contacts 125b, 125c, respectively) have a dielectric material 114 on its backside, as illustrated in Figs. 1A and 1C. For example, the source or drain region 126b is coupled to, such as in contact with, dielectric material 114b, and the source or drain region 126c is coupled to, such as in contact with, dielectric material 114c, as illustrated in Fig. 1C.

In one embodiment and as illustrated in Figs. 1A and 1C, lower surfaces of the backside source or drain contacts 140 and lower surfaces of the dielectric materials 114 are substantially coplanar, such as within a tolerance of at most 8 nm, or at most 5 nm, or at most 3 nm, or at most 2 nm, or at most 1 nm, for example. For example, the lower surfaces of the backside source or drain contacts 140a, 140d and lower surfaces of the dielectric materials 114b, 114c are substantially coplanar, as illustrated in Fig. 1C. Note that in the orientation illustrated in Figs. 1A-1C, "lower" implies towards the backside, and "upper" implies towards the frontside.

Note that as described below, trenches for the backside source or drain contacts 140a, 140d and the dielectric materials 114b, 114c are all formed from the frontside. Accordingly, each of the backside contacts 140a, 140d and the dielectric materials 114b, 114c are tapered. Accordingly, for each of these, a width of an upper surface is higher a width of the lower surface, e.g., by at least 10%, or at least 8%, or at least 5%, or at least 3%, or at least 2%, where the upper surface is towards the frontside and the lower surface is towards the backside. For example, Fig. 1C illustrates the source or drain contacts 140a, 140d and the dielectric materials 114b, 114c tapered in the manner described above. However, in other examples, although the trenches for the backside source or drain contacts 140a, 140d and the dielectric materials 114b, 114c formed from the frontside are initially tapered in the manner described above, the taper angle of one or more of these trenches can be changed during back-side processing, e.g., to make the backside surface wider than the frontside surface. For example, as described with respect to 311-31h below. some of the dielectric materials 114 are removed and replaced with the conductive material to form the source or drain contacts 140a, 140b. In such an example, after removal of the sacrificial dielectric material, an etch can blow out the corners of material 106 at the locations of the trenches for the source or drain contacts 140a and 140d. Thus, one or more of the backside source or drain contacts 140a, 140d may not taper in the manner described above.

In one embodiment and as described below, each of the devices of the device layer 150 comprises gate spacers 110 that separates a corresponding source or drain region 126 from a corresponding gate electrode 112. In an example and as also described below with respect to method 200 of Fig. 2, the dielectric materials 114 and the gate spacers 110 are deposited using the same deposition process. In an example, the dielectric materials 114 and the gate spacers 110 are elementally and/or compositionally same. In an example, the dielectric materials 114 and the gate spacers 110 comprise the same elemental constituents. In such an example, the dielectric materials 114 and the gate spacers 110 comprise a nitride, oxide, carbide, oxycarbide, oxynitride, and/or oxycarbonitride, such as silicon nitride (Si3N4), silicon oxycarbonitride (SiOCN), or another dielectric material used as gate spacers.

Although not illustrated in Figs. 1A-1D, in an example, a conductive lining layer may be between a source or drain region 126 and a corresponding source or drain contact 125 or 140. For example, the conductive lining layer may include one or more of silicide layer(s), germanide layer(s), germanosilicide layer(s), and/or adhesive layer(s) between the conductive source or drain metal contact and the adjacent source or drain region.

In one embodiment, the source or drain contacts 125, 140 comprise a conductive fill material, such as one or more of molybdenum (Mo), tungsten (W), cobalt (Co), titanium (Ti), vanadium (V), zirconium (Zr), Niobium (Nb), nickel (Ni), ruthenium (Ru), tantalum (Ta), titanium nitride (TiN), and/or vanadium nitride (VN), for example.

In one embodiment, in each device of the device layer 150, a gate structure wraps around each of the corresponding nanoribbons 103 in the corresponding channel region. The gate structures are visible in Figs. 1B and 1C. Each of the gate structures comprises a corresponding gate electrode 112 and corresponding dielectric material 128. The gate dielectric material 128 is illustrated in a magnified view of a section 115 of a device of the layer 150 in Fig. 1C. The gate dielectric material 128 warps around middle section of individual nanoribbons 103, and end sections of individual nanoribbons 103 are wrapped around by the gate spacers 110. The gate dielectric material 128 is between individual nanoribbons 103 and corresponding gate electrode 112, as illustrated. In an example, due to conformal deposition of the gate dielectric material 128, the gate dielectric material 128 may also be on inner sidewalls of the gate spacers 110, as illustrated.

The gate dielectric 128 may include a single material layer or multiple stacked material layers. The gate dielectric may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. The high-k dielectric material (e.g., hafnium oxide) may be doped with an element to affect the threshold voltage of the given semiconductor device. According to some embodiments, the doping element used in gate dielectric 128 is lanthanum. In some embodiments, the gate dielectric can be annealed to improve its quality when high-k dielectric material is used. In some embodiments, the gate dielectric 128 includes a first layer (e.g., native oxide of nanoribbons, such as silicon dioxide or germanium oxide or SiGe-oxide) on the nanoribbons, and a second layer of high-k dielectric (e.g., hafnium oxide) on the first layer.

In an example, the gate electrodes 112 of the various devices of the device layer 150 may include any sufficiently conductive material, such as a metal, metal alloy, or doped polysilicon. The gate electrodes 112 may include a wide range of materials, such as polysilicon or various suitable metals or metal alloys, such as aluminum, tungsten, titanium, tantalum, copper, cobalt, molybdenum, titanium nitride, or tantalum nitride, for example.

In one embodiment, one or more work function materials (not illustrated in Figs. 1B and 1C) may be included around the nanoribbons 103. Note that work function materials are called out separately, but may be considered to be part of the gate electrodes. In this manner, a gate electrode may include multiple layers or components, including one or more work function materials, gate fill material, capping or resistance-reducing material, to name a few examples. In some embodiments, a p-channel device may include a work function metal having titanium, and an n-channel device may include a work function metal having tungsten or aluminum, although other material and combination may also be possible. In some other embodiments, the work function metal may be absent around one or more nanoribbons 103. In still other embodiments, there may be insufficient room for any gate fill material, after deposition of work function material (i.e., a given gate electrode may be all work function material and no fill material). Numerous gate structure configurations can be used along with the techniques provided herein, and the present disclosure is not intended to be limited to any particular such configurations.

Each of gate structures including the gate electrode 112 and the gate dielectric material 128 can be formed via gate-first or gate-last processing, and may include any number of suitable gate materials and configurations. Gate spacers 110 isolate the gate structures from contacting the corresponding source or drain regions. In one example the gate spacers 110 may be considered part of the gate structure, whereas in another example the gate spacers 110 may be considered external to the gate structure.

As described above, the dielectric materials 114 and the gate spacers 110 are deposited using the same deposition process. In an example, the dielectric materials 114 and the gate spacers 110 are elementally and/or compositionally same, and comprise the same elemental constituents. In such an example, the dielectric materials 114 and the gate spacers 110 comprise a nitride, oxide, carbide, oxycarbide, oxynitride, and/or oxycarbonitride, such as silicon nitride, silicon oxycarbonitride (SiOCN), or another dielectric material.

The semiconductor bodies 103 of the channel regions of the various devices, which in this case are nanoribbons, can be any number of semiconductor materials as well, such as group IV material (e.g., silicon, germanium, or SiGe) or group III-V materials (e.g., indium gallium arsenide). The semiconductor bodies 103 may be lightly doped, or undoped, and may be shaped or sculpted during the gate formation process, according to some embodiments. In some cases, semiconductor bodies 103 may be a multilayer structure, such as a SiGe body cladded with germanium, or a silicon body cladded with SiGe. Any number of channel configurations can be used.

Figs. 1E, 1F, 1G, and 1H illustrate various views of another integrated circuit structure 170 (also referred to herein as "structure 170") that is at least in part similar to the integrated circuit structure 100 of Figs. 1A-1D, wherein in the integrated circuit structure 170 of Figs. 1E-1H, a backside source or drain contact 180 has a stepped sidewall, in accordance with an embodiment of the present disclosure. The views of Figs. 1E-1H are respectively similar to the view of Figs. 1A-1D (such as Figs. 1E-1G illustrate various cross-sectional views, and Fig. 1H illustrates a plan view when viewed from the backside).

The integrated circuit structure 170 of Figs. 1E-1H is at least in part similar to the integrated circuit structure 100 of Figs. 1A-1D, and common and similar components in both structures are labelled using the same labels. For example, as illustrated in Fig. 1G, the structure 170 comprises the source or drain regions 126a, 126b, 126c, 126d. Frontside source or drain contacts 125b and 125c are coupled to the frontside of the source or drain contacts 126b, 126d, respectively. Also, backside source or drain contacts 180a and 180d are coupled to the backside of the source or drain contacts 126a, 126d, respectively. Also, dielectric material 120 is coupled to the frontside of the source or drain regions 126a, 126d. Dielectric materials 114b and 114c are respectively coupled to the backside of the source or drain regions 126b, 126c. As described with respect to Figs. 1A-1D, in Figs. 1E-1H the dielectric materials 114b and 114c are deposited in the same process as the gate spacers 110, and the dielectric materials 114b and 114c and the gate spacers 110 are compositionally and/or elementally the same, and comprise the same elemental constituents.

In the structure 100 of Figs. 1A-1D, the lower surfaces of the backside source or drain contacts 140a and 140d and the dielectric materials 114b, 114c are substantially coplanar (e.g., within a tolerance described above). In contrast, the lower surfaces of the backside source or drain contacts 180a and 180d are not coplanar with the lower surfaces of the dielectric materials 114b, 114c. For example, at least sections of the lower surfaces of the dielectric materials 114b, 114c are at an upper horizontal plane, and at least sections of the lower surfaces of the backside source or drain contacts 180a, 180b are at a lower horizontal plane, wherein the lower horizontal plane is lower than the upper horizontal plane by at least 3 nm, or at least 4 nm, or at least 5 nm, or at least 7 nm, or at least 10 nm, or at least 12 nm, for example, as illustrated in Fig. 1G.

In an example, a sidewall of each of the backside source or drain contacts 180a, 180b have a step feature, such as a stepped sidewall. For example, referring to the backside source or drain contact 180a in Fig. 1G, the sidewall has a first section 181, a second section 182, and an intervening step section 183 between the first and second sections. The section 181 tapers or otherwise steps inward of section 182, towards a center of the source or drain contact 180a, and the section 182 of this example is shorter and more vertical. The step section 183 is horizontal in this example, but more generally may extend more in the horizontal direction than in the vertical direction, such that the angle formed by the step section 183 relative to a horizontal axis is less than 45 degrees. Said differently, the step section 183 is closer to being horizontal than it is closer to being vertical.

In an example, the substantially horizontal step section 183 of the source or drain contact 180a is substantially within the same plane as the lower surfaces of the dielectric materials 114b, 114c, with a tolerance of at most 5 nm, or at most 3 nm, or at most 2 nm, for example. Thus, a vertical height of the section 181 of the sidewall of the source or drain contact 180a and a vertical height of the dielectric materials 114b, 114c are substantially the same (e.g., represented by "h" in Fig. 1G), e.g., within a tolerance of at most 5 nm, or at most 3 nm, or at most 2 nm. Remaining components of the structure 170 of Figs. 1E-1H will be apparent, in view of the above described components of the structure 100 of Figs. 1A-1D.

Fig. 2 illustrates a flowchart depicting a method 200 of forming the example integrated circuit structures 100 and 170 of Figs. 1A-1H, in accordance with an embodiment of the present disclosure. Figs. 3A1, 3A2, 3A3, 3B1, 3B2, 3B3, 3C1, 3C2, 3C3, 3Ca, 3Cb, 3Cc, 3D1, 3D2, 3D3, 3Da, 3Db, 3Dc, 3E1, 3E2, 3E3, 3Ea, 3Eb, 3Ec, 3F1, 3F2, 3F3, 3F4, 3Fa, 3Fb, 3Fc, 3Fd, 3G1, 3G2, 3G3, 3G4, 3Ga, 3Gb, 3Gc, 3Gd, 3H1, 3H2, 3H3, 3H4, 3Ha, 3Hb, 3Hc, 3Hd, 3I1, 3I2, 3I3, 3I4, 3Ia, 3Ib, 3Ic, 3Id, 3Ie, 3If, 3Ig, 3Ih, 3J1, 3J2, 3J3, 3J4, 3Ja, 3Jb, 3Jc, 3Jd, 3K1, 3K2, 3K3, 3K4, 3Ka, 3Kb, 3Kc, and 3Kd collectively illustrate cross-sectional views of example integrated circuit structures 100, 170 in various stages of processing in accordance with the methodology of Fig. 2, in accordance with an embodiment of the present disclosure. Figs. 2 and 3A1-3Kd will be discussed in unison.

Note that Figs. 3A1, 3A2, 3A3, 3B1, 3B2, 3B3, 3C1, 3C2, 3C3, 3D1, 3D2, 3D3, 3E1, 3E2, 3E3, 3F1, 3F2, 3F3, 3F4, 3G1, 3G2, 3G3, 3G4, 3H1, 3H2, 3H3, 3H4, 3I1, 3I2, 3I3, 3I4, 3J1, 3J2, 3J3, 3J4, 3K1, 3K2, 3K3, and 3K4 collectively illustrate cross-sectional views of the integrated circuit structure 100 of Figs. 1A-1D in various stages of processing. On the other hand, Figs. 3A1, 3A2, 3A3, 3B1, 3B2, 3B3, 3Ca, 3Cb, 3Cc, 3Da, 3Db, 3Dc, 3Ea, 3Eb, 3Ec, 3Fa, 3Fb, 3Fc, 3Fd, 3Ga, 3Gb, 3Gc, 3Gd, 3Ha, 3Hb, 3Hc, 3Hd, 3Ia, 3Ib, 3Ic, 3Id, 3Ie, 3If, 3Ig, 3Ih, 3Ja, 3Jb, 3Jc, 3Jd, 3Ka, 3Kb, 3Kc, and 3Kd collectively illustrate cross-sectional views of the integrated circuit structure 170 of Figs. 1E-1H in various stages of processing. Thus, 3A1-3B3 is common to both the integrated circuit structures 100 and 170.

The cross-sectional views of Figs. 3A1, 3B1, 3C1, 3Cc, 3D1, 3Da, 3E1, 3Ea, 3F1, 3Fa, 3G1, 3Ga, 3H1, 3Ha, 3I1, 3Ia, 3Ie, 3J1, 3Ja, 3K1, and 3Ka correspond to the cross-sectional views of Figs. 1A and/or 1E, and are taken parallel to, and through, the source or drain regions (e.g., are channel-cut views centered on the source or drain regions).

The cross-sectional views of 3A2, 3B2, 3C2, 3Cb, 3D2, 3Db, 3E2, 3Eb, 3F2, 3Fb, 3G2, 3Gb, 3H2, 3Hb, 3I2, 3Ib, 3If, 3J2, 3Jb, 3K2, and 3Kb correspond to the cross-sectional views of Figs. 1B and/or 1F, and are taken parallel to, and through, the gate stack (e.g., are channel-cut views centered on the gate stack, and the source or drain regions are not illustrated in these figures).

The cross-sectional views of Figs. 3A3, 3B3, 3C3, 3Cc, 3D3, 3Dc, 3E3, 3Ec, 3F3, 3Fc, 3G3, 3Gc, 3H3, 3Hc, 3I3, 3Ic, 3Ig, 3J3, 3Jc, 3K3, and 3Kc correspond to the cross-sectional views of Figs. 1C and/or 1G, and are taken parallel to, and through, the fin structure (e.g., by cutting through the gate stack), such that the channel, source, and drain regions are shown (e.g., are gate-cut views centered on the channel regions).

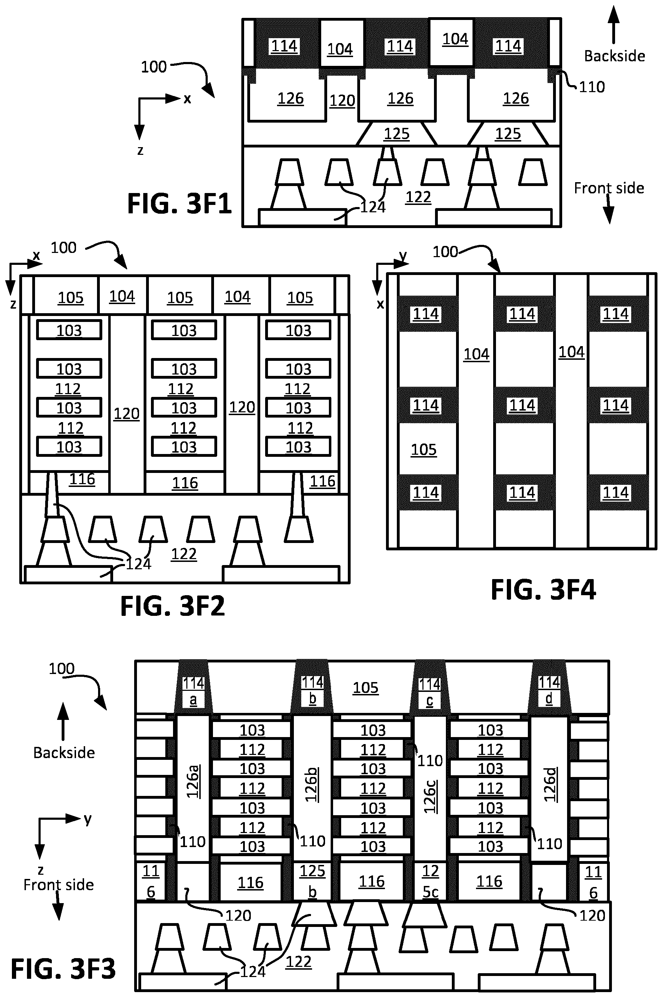

The cross-sectional views of each of Figs. 3F4, 3Fd, 3G4, 3Gd, 3H4, 3Hd, 3I4, 3Id, 3Ih, 3J4, 3Jd, 3K4, and 3Kd correspond to the cross-sectional views of Figs. 1D and/or 1H, and are plan views of the structures 100 or 170, when viewed from the backside (e.g., along lines D-D' of Figs. 1B and 1C).

Referring to Fig. 2, at 204 of method 200, a stack of alternating sacrificial material layers 303 and semiconductor material layers 103 is formed, and the stack is selectively etched to define a plurality of fins, where each fin comprises alternating sacrificial material layers 303 and semiconductor material layers 103 above corresponding sub-fin 105 and substrate 107. Subsequently, a dummy gate stack 307 is formed, as illustrated in Figs. 3A1, 3A2, and 3A3. Note that Figs. 3A1, 3A2, and 3A3 are common to formation of structures 100 and 170.

In an example, the structure 100 or 170 of Figs. 3A1-3A3 is formed using techniques to form such structures in GAA devices. In an example, the sacrificial material layers 303 comprises SiGe. The sacrificial material layer 303 is etch selective to the channel material layer 103, e.g., such that the sacrificial material layer 303 can be later etched and removed (e.g., during nanoribbon release process), without substantially etching the channel material layer 303. Individual ones of the sacrificial material layers 303 and the channel material layers 103 of the stack is formed using an appropriate deposition or epitaxial growth technique, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. In one embodiment, etching the stack to define the fins can be performed using any suitable techniques for etching and defining fins. For example, regions to be processed into the fins are masked, followed by etching the surrounding regions to define the fins. For instance, an anisotropic etch proceeds substantially vertically through the upper fin portion to define isolation trenches between adjacent fins. In an example, the dummy gate structure 307 comprises dummy gate electrode, which may comprise poly-Si, for example. Also illustrated are isolation regions 104, such as shallow trench isolation (STI) regions 104 comprising dielectric material between adjacent sub-fins 105.

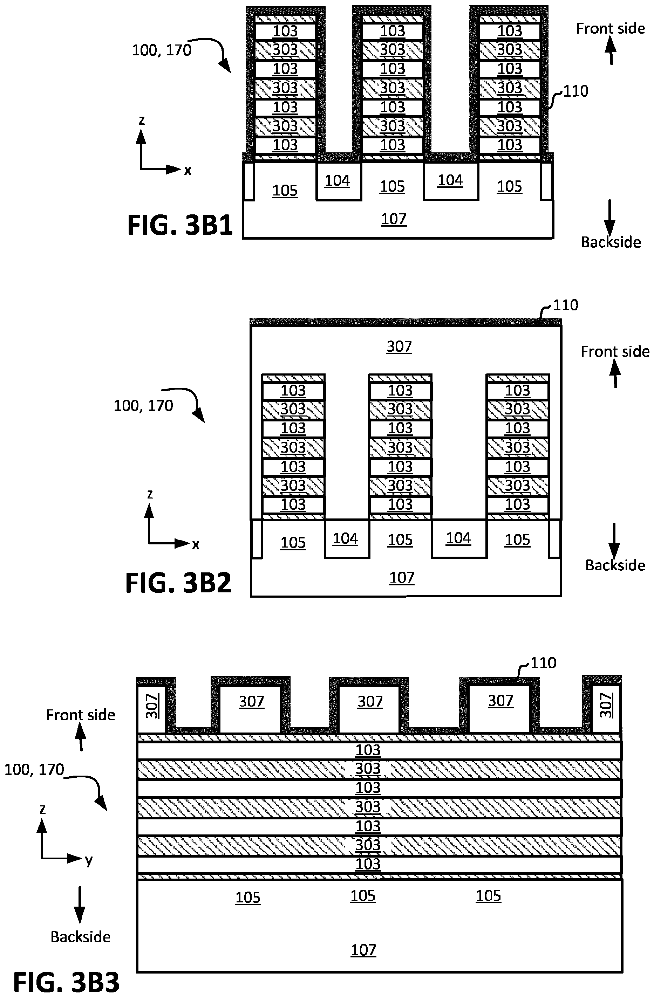

Referring again to the method 200 of Fig. 2, the method 200 proceeds from 204 to 208. At 208, gate spacer material 110 is deposited above the dummy gate 307 and the fins, as illustrated in Figs. 3B1, 3B2, and 3B3. Note that Figs. 3B1, 3B2, and 3B3 are common to formation of structures 100 and 170.

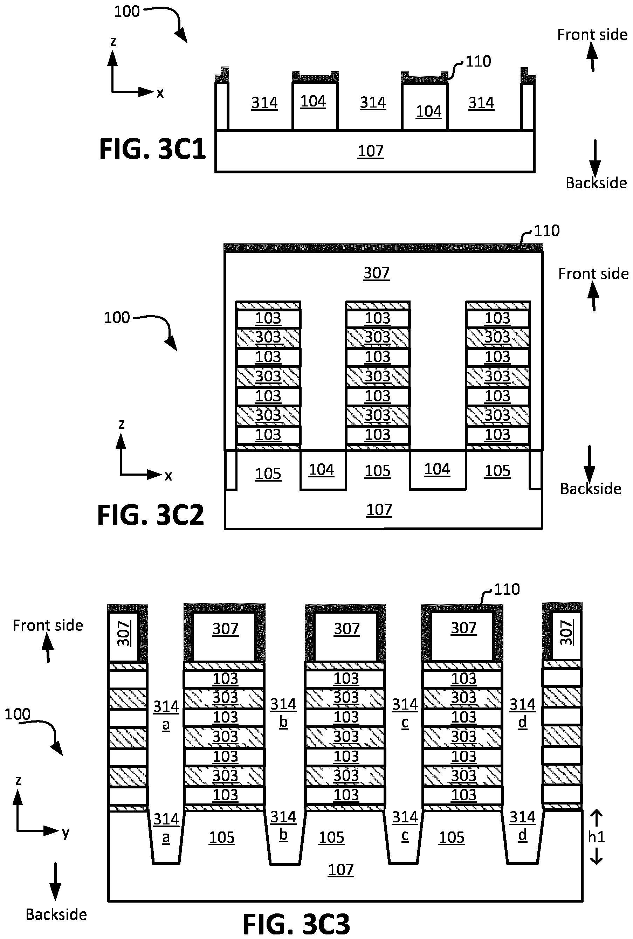

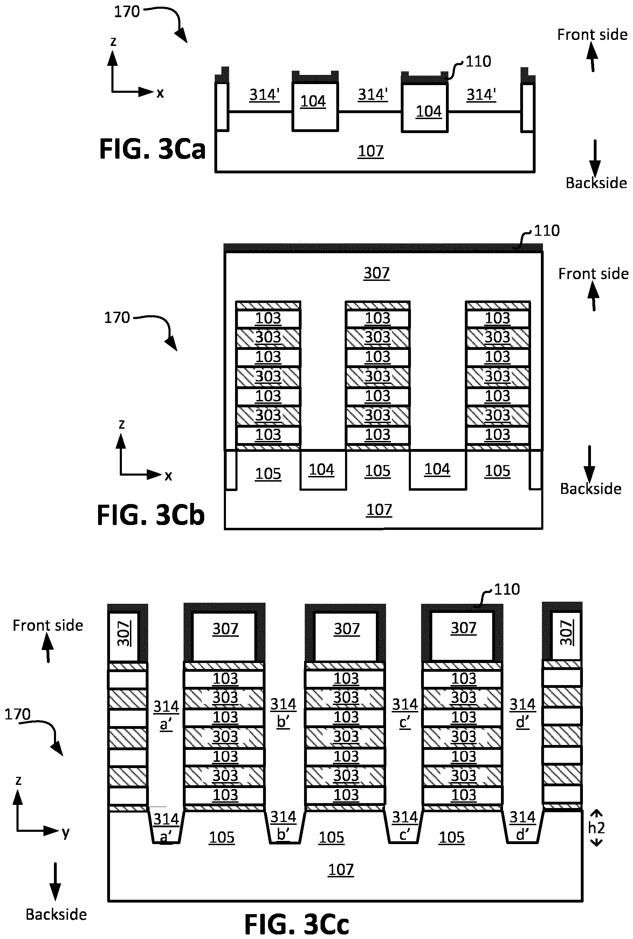

Referring again to the method 200 of Fig. 2, the method 200 proceeds from 208 to 212. At 212, the gate spacer material 110 is selectively etched, and sections of the fins are also selectively etched to form either (i) source or drain trenches 314a, 314b, 314c, 314, as illustrated in Figs.3C1, 3C2, 3C3, or (ii) source or drain trenches 314a', 314b', 314c', 314d', as illustrated in Figs. 3Ca, 3Cb, 3C3.

Note that Figs. 3C1, 3C2, and 3C3 are for formation of the structure 100, while Figs. 3Ca, 3Cb, and 3Cc are for formation of the structure 170.

As illustrated in Figs. 3C3, the source or drain trenches 314a, 314b, 314c, 314d are etched deeper, so as to extend within the sub-fin area, such that portions of the source or drain trenches 314a, 314b, 314c, 314d extending within the sub-fin 105 have a height of h1. In contrast, as illustrated in Fig. 3Cc, the source or drain trenches 314a', 314b', 314c', 314d' are etched deeper (but not as deep as the source or drain trenches 314a, 314b, 314c, 314d), so as to extend within the sub-fin area 105, such that portion of the source or drain trenches 314a', 314b', 314c', 314d' extending within the sub-fin 105 have a height of h2, where height h2 is less than h1.

So, depending on the process used, the source or drain trenches may be extended deeper within the sub-fin area 105 (e.g., up to a height of h1, see Figs. 3C3), or less deep within the sub-fin area 105 (e.g., up to a height of h2, see Fig. 3Cc). Extending the source or drain trenches to the height of h1 of Figs. 3C1-3C3 results in formation of the structure 100; and extending the source or drain trenches to the height of h2 of Figs. 3Ca-3Cc results in formation of the structure 170.

Note that sections of the sub-fins are also etched during the process 212, such that the source or drain trenches extend into the sub-fin. In contrast, in general GAA devices, the source or drain trenches may not extend to such depths. For example, in Figs. 3C3, a portion of each of the trenches 314a, 314b, 314c, 314 are laterally between two sub-fin areas of two adjacent devices. Similarly, in Figs. 3C1, the sections of the sub-fins are removed, to form the trenches 314 between the isolation regions 104. The trenches are etched deeper, e.g., to facilitate formation of backside source or drain contacts, as described below. In an example, sections of the spacer 110 above the isolation region may be preserved, as illustrated in Figs. 3C1.

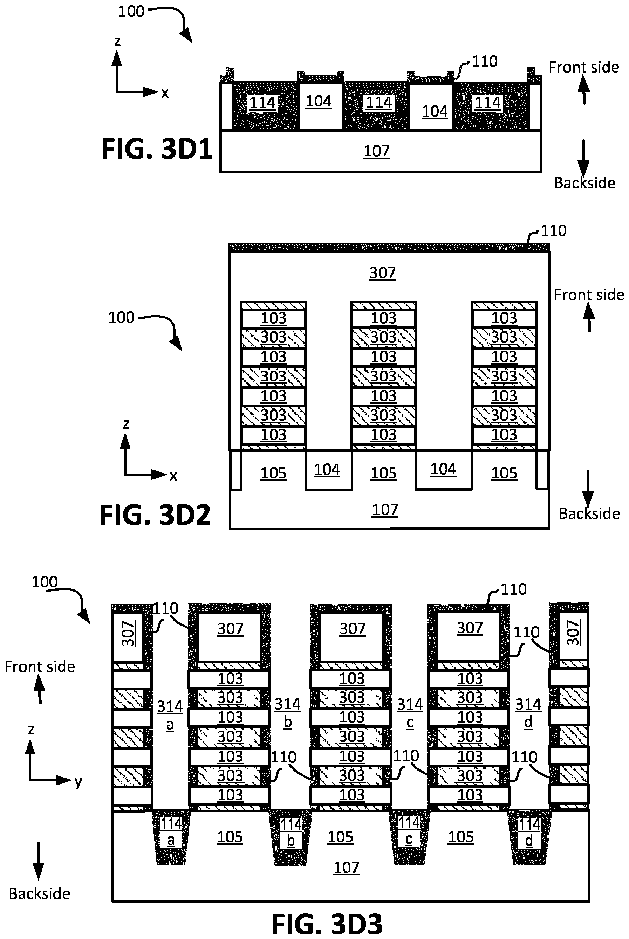

Referring again to the method 200 of Fig. 2, the method 200 proceeds from 212 to 216. At 216, gate spacers 110 abutting the channel material 103 are formed, and the material of the gate spacer 110 is also deposited (i) within sections of the source or drain trenches 314a, 314b, 314c, 314d (e.g., that extend within the sub-fin area) as dielectric material 114a, 114b, 114c, 114d, respectively, as illustrated in Fig. 3D3, or (ii) within sections of the source or drain trenches 314a', 314b', 314c', 314d' (e.g., that extend within the sub-fin area) as dielectric material 114a', 114b', 114c', 114d', respectively, as illustrated in Fig. 3Dc. The gate spacers 110 formed in process 216 are inner gate spacers that will eventually separate the source or drain regions from corresponding gate electrode. The gate spacers 110 are formed using techniques for forming such gate spacers in GAA devices. For example, end sections of the sacrificial material 303 are etched through the source or drain trenches, and the gate spacers 110 are deposited. Subsequently, the gate spacers 110 are planarized (e.g., through a gate spacer etch process), such that the end sections of the nanoribbons 103 are exposed through the gate spacers 110 (e.g., see Fig. 3D3 or 3Dc). Additionally, the dielectric material for the gate spacers 110 is also deposited in deeper sections of the trenches 314a, 314b, 314c, 314d (or trenches 314a', 314b', 314c', 314d'), to respectively form dielectric materials 114a, 114b, 114c, 114d, as illustrated in Fig. 3D3 and Fig. 3Dc.

Note that a height of the dielectric materials 114a, 114b, 114c, 114d in Fig. 3D3 is more than a height of the dielectric materials 114a, 114b, 114c, 114d in Fig. 3Dc, due to the above described height h2 being more than height h1. In an example, during the gate spacer etch process (e.g., when the gate spacers are planarized), portions of the material of the gate spacers 110 (e.g., the dielectric materials 114a, 114b, 114c, 114d) between the sub-fin areas are not substantially etched.

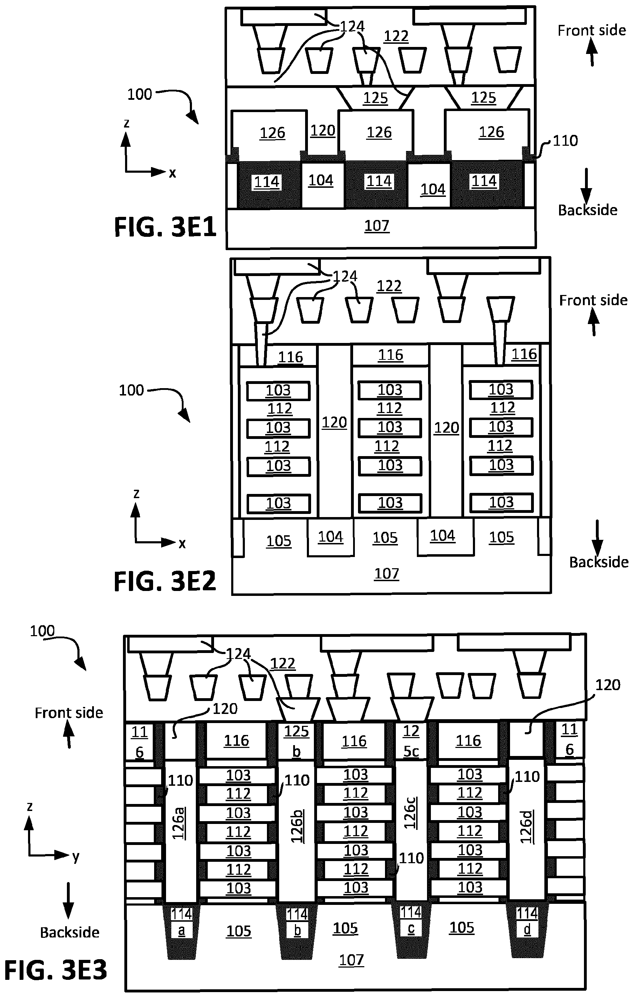

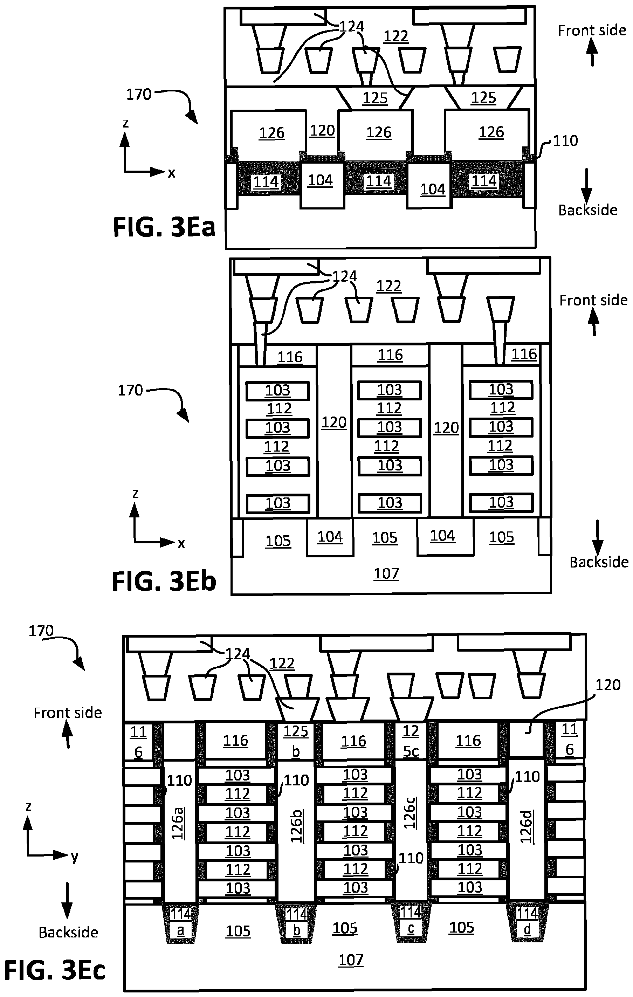

Referring again to the method 200 of Fig. 2, the method 200 proceeds from 216 to 220. At 220, the source and drain regions 126 are formed, the dummy gate stacks 307 are removed, the nanoribbons 103 are released (e.g., by removing the sacrificial material 303), the final gate stack comprising the gate electrodes 112 and gate dielectric 128 are formed, the frontside gate contacts 116 are formed, the frontside source or drain contacts 125b, 125c are formed, and the frontside interconnect structure 102 is formed, e.g., using techniques to form at least sections of the device layer 150 comprising the GAA devices and the frontside interconnect structure 102, as illustrated in Figs. 3E1, 3E2, and 3E3, and as also illustrated in Figs. 3Ea, 3Eb, and 3Ec.

Note that the frontside source or drain contacts 125b and 125c are formed above the corresponding source or drain regions 126b and 126c, respectively, see Figs. 3E3 and 3Ec. The source or drain trenches above the source or drain regions 126a and 126d are not opened, and hence, no frontside source or drain contacts are formed above the source or drain regions 126a, 126d. Also, each of the source or drain regions 126a, ..., 126d has corresponding dielectric materials 114a, ..., 114d, respectively, there below, as illustrated in Fig. 3E3 and 3Ec. Each of the dielectric materials 114a, ..., 114d is laterally between two sub-fins 105.

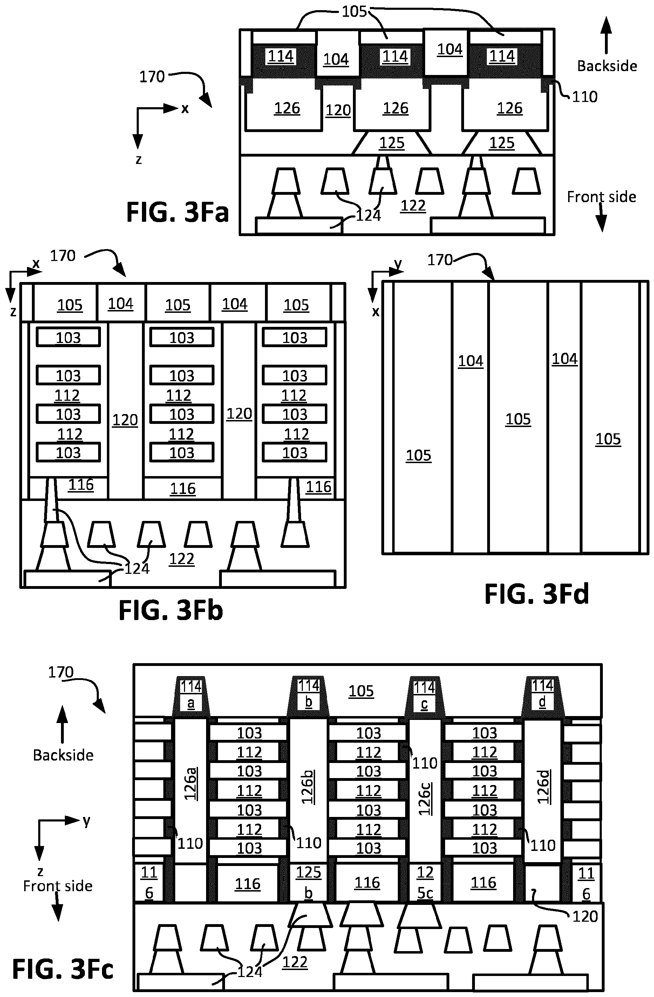

Referring again to the method 200 of Fig. 2, the method 200 proceeds from 220 to 224. At 224, the device wafer is bonded to a carrier, the bonded wafer is flipped, and the device substrate 107 is at least in part removed from the backside, as illustrated in Figs. 3F1, 3F2, 3F3, and 3F4, and as also illustrated in Figs. 3Fa, 3Fb, 3Fc, and 3Fd.

Note that the dielectric materials 114a, ..., 114d are deeper in Figs. 3F1-3F4, and hence, during the substrate 107 removal process, the lower surfaces of the dielectric materials 114a, ..., 114d are revealed in Figs. 3F1, 3F2, 3F3, and 3F4. In contrast, the dielectric materials 114a, ..., 114d is less deep in Figs. 3Fa-3Fd, and hence, during the substrate 107 removal process, the lower surfaces of the dielectric materials 114a, ..., 114d are not revealed in Figs. 3Fa, 3Fb, 3Fc, and 3Fd.

Because the wafer is flipped, the backside is above the frontside in the orientations of Figs. 3F1, 3F2, and 3F3, and 3Fa, 3Fb, and 3Fc. The substrate is removed, for example with a mechanical polish process, or a chemical mechanical polish (CMP) process, or an etch process.

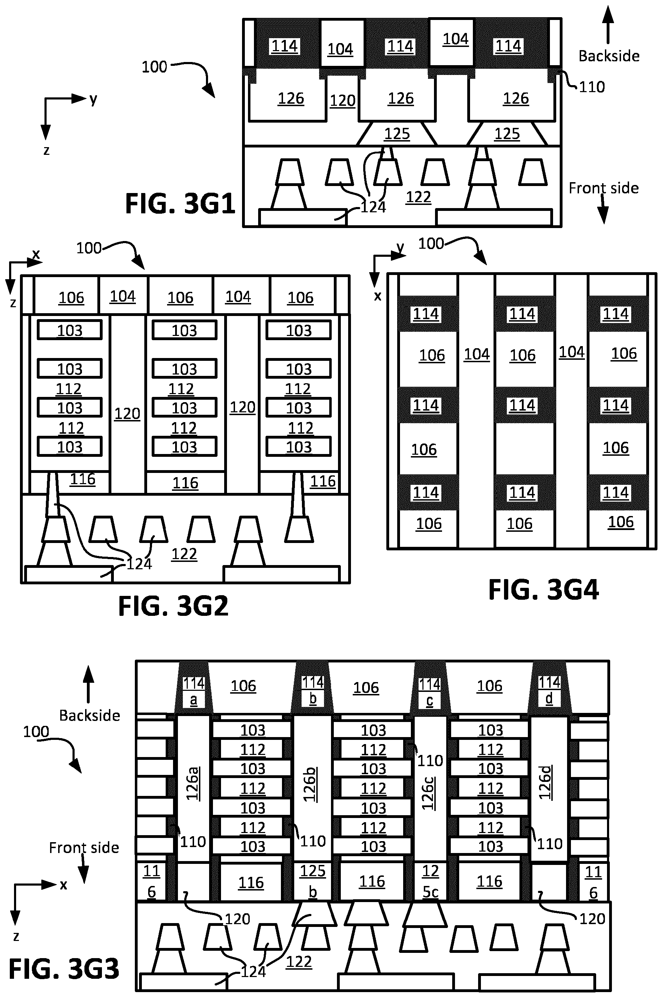

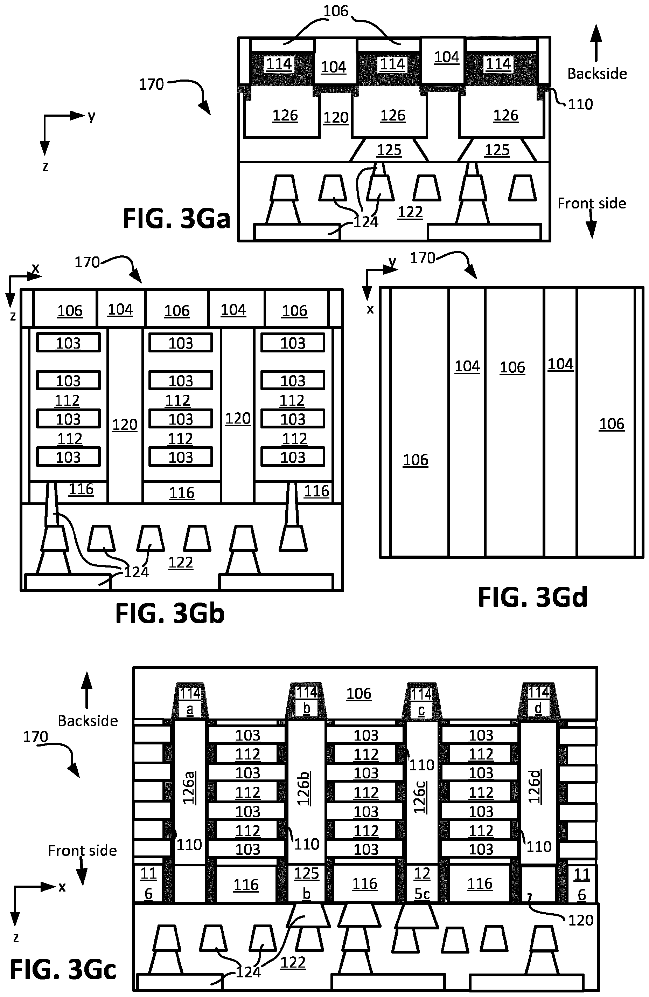

Referring again to the method 200 of Fig. 2, the method 200 proceeds from 224 to 228. At 228, from backside, the material of the sub-fins 105 are at least partially replaced with corresponding dielectric material 106, as illustrated in Figs. 3G1, 3G2, 3G3, 3G4, and as also illustrated in Figs. 3Ga, 3Gb, 3Gc, 3Gd. Note that in Figs. 3G4, in the plan view when viewed from the backside, the STI 104 are visible, along with the dielectric material 106 and the dielectric materials 114 (such as dielectric materials 114a, ..., 114d). In contrast, in Fig. 3Gd, in the plan view when viewed from the backside, the STI 104 are visible along with the dielectric material 106, and the dielectric materials 114 (such as dielectric materials 114a, ..., 114d) are covered by the dielectric material 106 and not exposed through the backside.

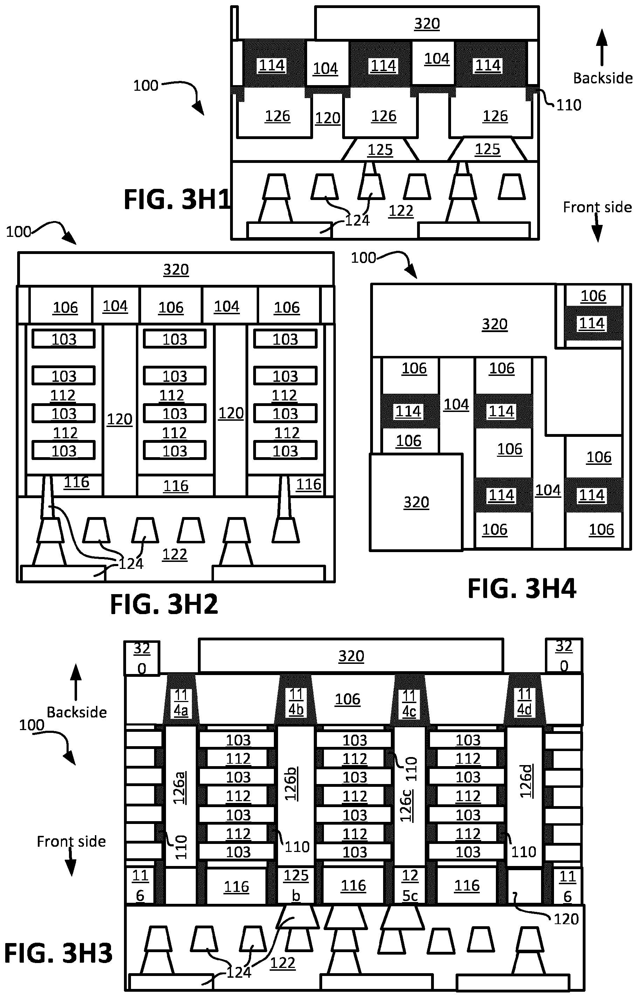

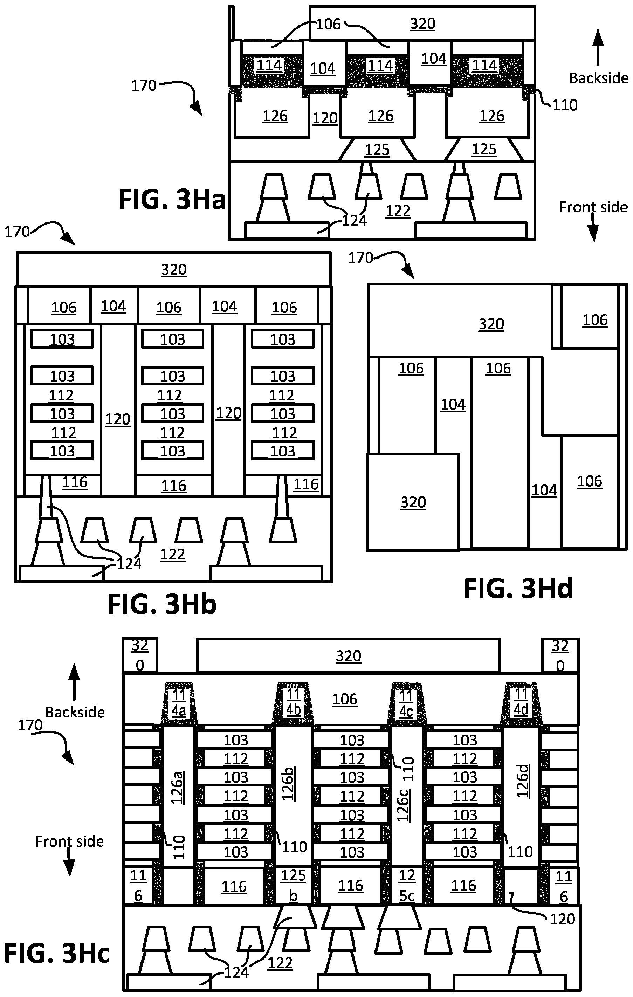

Referring again to the method 200 of Fig. 2, the method 200 proceeds from 228 to 232. At 232, a mask 320 is patterned on the backside, such that the mask 320 has openings above the dielectric material 114 coupled to one or more source or drain regions for which backside source or drain contacts are desired, as illustrated in 3H1, 3H2, 3H3, and3H4, and as also illustrated in Figs. 3Ha, 3Hb, 3Hc, and 3Hd. For example, Fig. 3H3 illustrates openings within the mask 320 above the dielectric materials 114a, 114d of the source or drain regions 114a, 114d, respectively, wherein backside source or drain contacts are desired for the source or drain regions 114a, 114d. In the plan view of Fig. 3H4, the mask 320 is illustrated to mask one or more instances of the dielectric material 114, while exposing one or more other instances of the dielectric material 114.

In contrast, in Figs. 3Ha-3Hd, although the openings within the mask 320 are above the dielectric materials 114a, 114d, respectively, the dielectric materials 114a, 114d are not exposed through the openings, for being covered by the dielectric material 106.

The mask 320 may be of any appropriate type, and may include one or more layers (such as a tri-layer mask). The mask 320 comprises titanium nitride (TiN), tungsten doped carbide, or a carbon based hard mask, for example. The mask 320 defines openings for backside source or drain contacts.

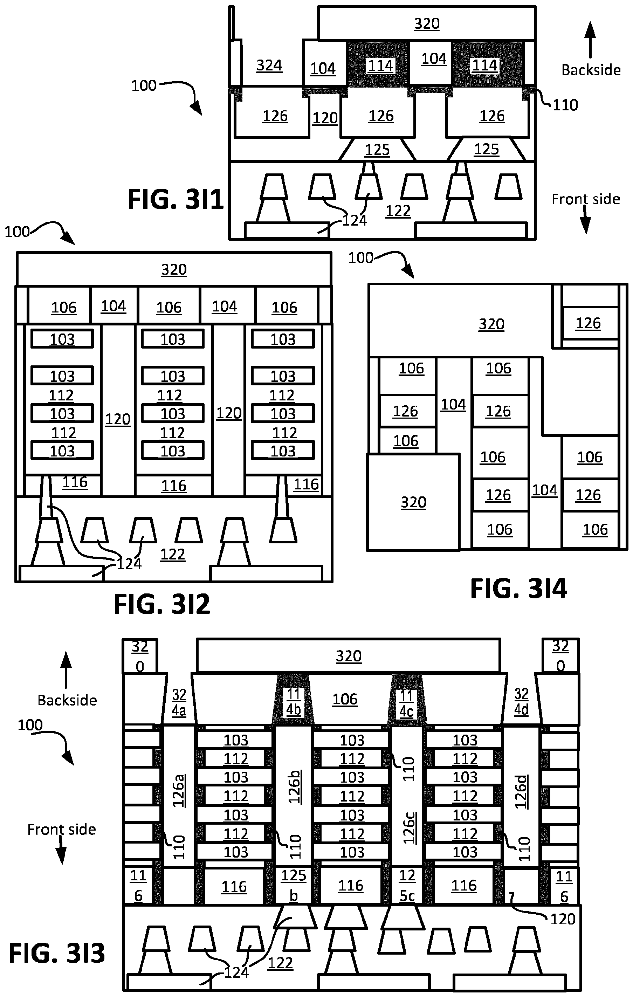

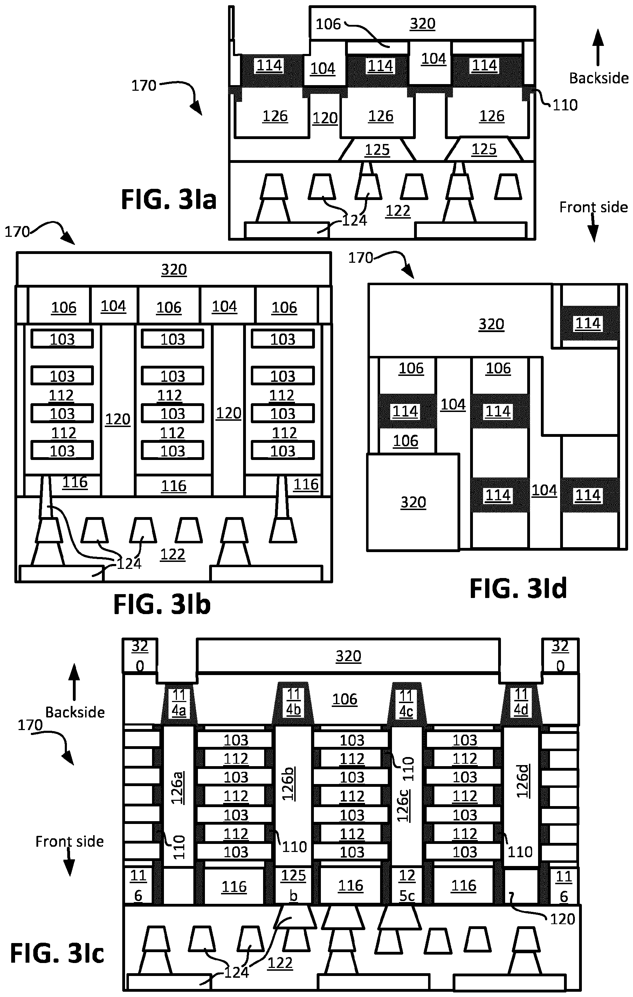

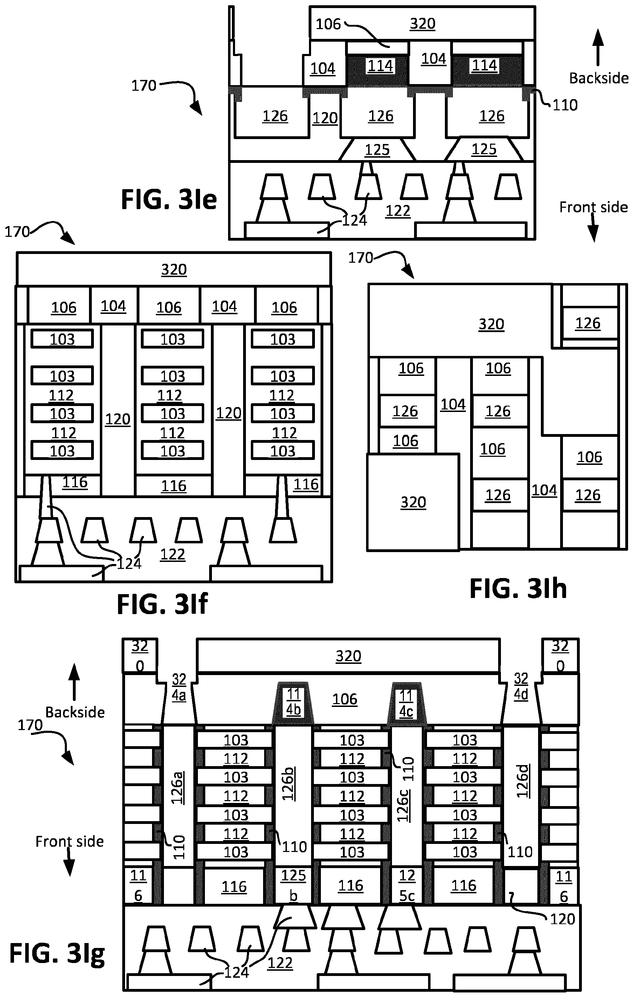

Referring again to the method 200 of Fig. 2, the method 200 proceeds from 232 to 236. At 236, one or more instances of the dielectric material 114 are removed (e.g., to form corresponding recesses 324) through the openings within the mask 320, while one or more other instances of the dielectric material 114 covered by mask 320 are not removed, as illustrated in Figs. 3I1, 3I2, 3I3, and3I4, and as also illustrated in Figs. 3Ia, 3Ib, 3Ic, 3Id, 3Ie, 3If, 3Ig, and 3Ih.

In Figs. 3I1-3I4, the dielectric material 114a, 114d exposed through the openings within the mask 320 are removed, e.g., etched, to form recesses 324. Note that the recesses 324 are self-aligned to the corresponding source or drain regions 126. For example, the recess 324a is self-aligned to the corresponding source or drain region 126a, and the recess 324b is self-aligned to the corresponding source or drain region 126b. This consequently results in the later formed source or drain contacts 140a, 140b being self-aligned to the source or drain regions 126a, 126d, respectively.

In Figs. 3Ia-3Ih, the dielectric material 114a, 114d are removed using two different removal processes. For example, in Figs. 3Ia-3Id, sections of the dielectric material 106, which are above the dielectric materials 114a, 114d and which are exposed through the openings within the masks 320, are removed initially, thereby exposing the dielectric materials 114a, 114d through the openings within the masks 320. Subsequently, in Figs. 3Ie-3Ih, the dielectric material 114a, 114d exposed through the openings within the mask 320 are removed. Because of the two different etch processes in Figs. 3Ia-3Ih, the sidewalls of the recesses 324a, 324d (e.g., which are formed due to the removal of the dielectric materials 114a, 114d) are stepped, which eventually results in the sidewalls of the source or drain contacts 180a, 180d being also stepped (see Fig. 1G). Note that the recesses 324 are self-aligned to the corresponding source or drain regions 126.

Thus, subsequent to process 236, one or more source or drain regions are now exposed from the backside. For example, Figs. 3I3 and 3Ig illustrate dielectric material 114a being removed, resulting in recess 324a, and hence, the source or drain region 126a being exposed from the backside through the recess 324a. Similarly, Figs. 3I3 and 3Ig also illustrate dielectric material 114d being removed, resulting in recess 324d, and hence, the source or drain region 126d being exposed from the backside through the recess 324d. The source or drain regions 126b, 126c are covered by the dielectric materials 114b, 114c, respectively, as the dielectric materials 114b, 114c are not removed for being covered by the mask 320. Note that the etch process may round off some of the surrounding dielectric material, such as dielectric material 106.

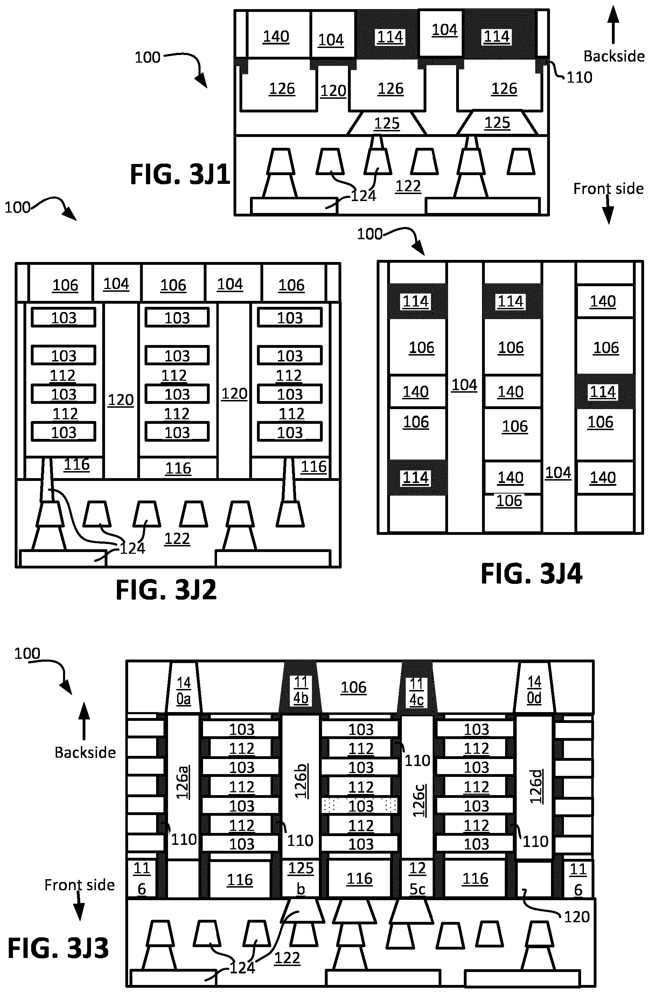

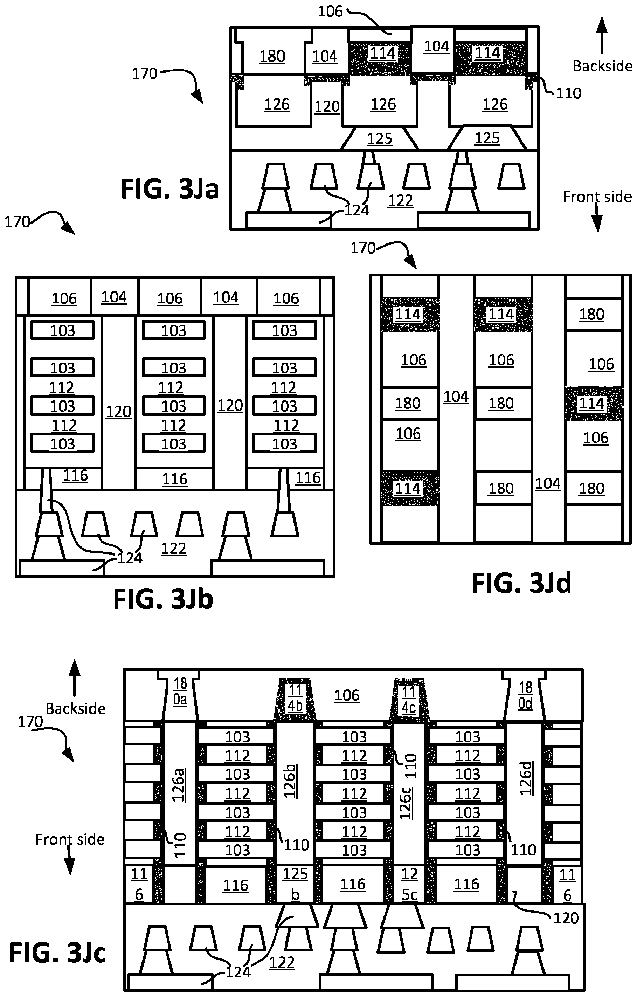

Referring again to the method 200 of Fig. 2, the method 200 proceeds from 236 to 240. At 240, the mask 320 is removed, and conductive material is deposited within the recesses 324 formed by selective removal of the dielectric material 114 and planarized to the top surface of dielectrics 104 and 106 (e.g., where the planarization is within a tolerance of at most 5 nm, or at most 3 nm, or at most 2 nm, or at most 1 nm, for example), as illustrated in Figs. 3J1, 3J2, 3J3, and 3J4, and as also illustrated in Figs. 3Ja, 3Jb, 3Jc, and 3Jd. For example, deposition of the conductive materials results in formation of the backside source or drain contacts 140a and 140b respectively coupled to the source or drain regions 126a, 126b, as illustrated inFig. 3J3, or formation of the backside source or drain contacts 180a and 180b respectively coupled to the source or drain regions 126a, 126b, as illustrated in Fig. 3Jc. Note the stepped sidewalls of the backside source or drain contacts 180a and 180b of Fig. 3Jc, due to the above described two step removal process 236 described above. Example conductive material for the backside source or drain contacts have been described above.

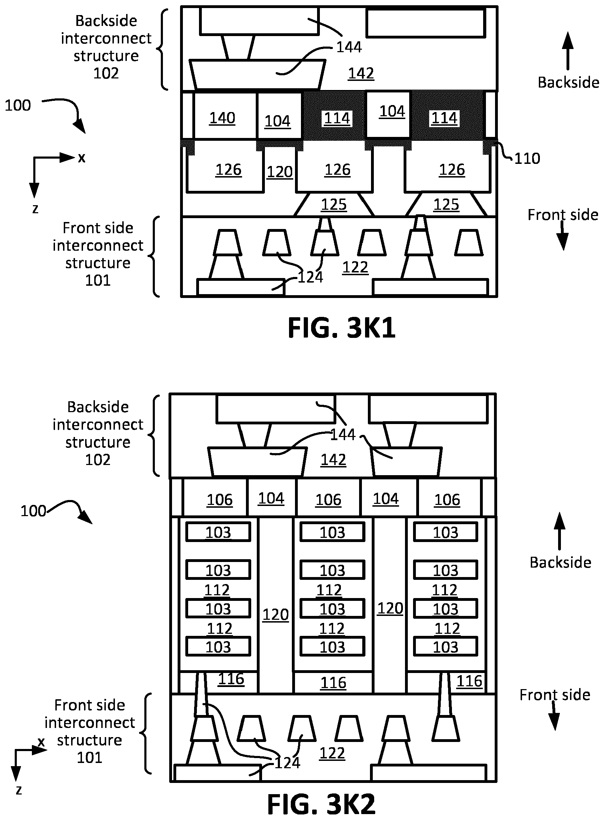

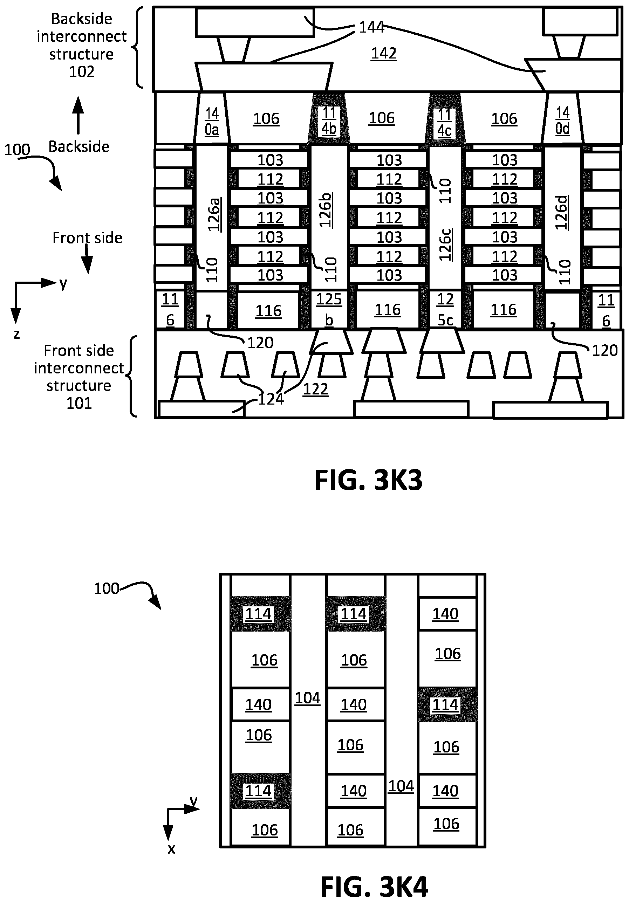

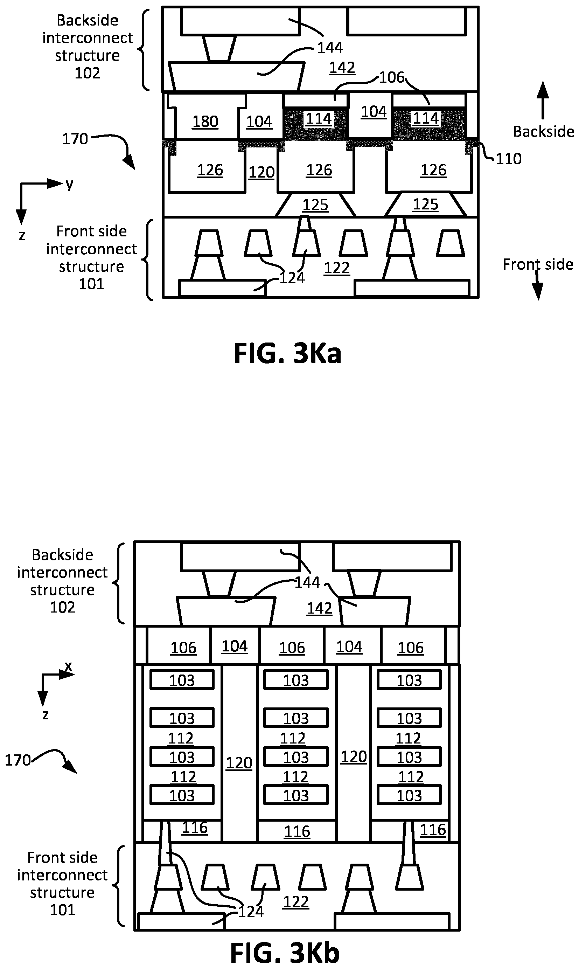

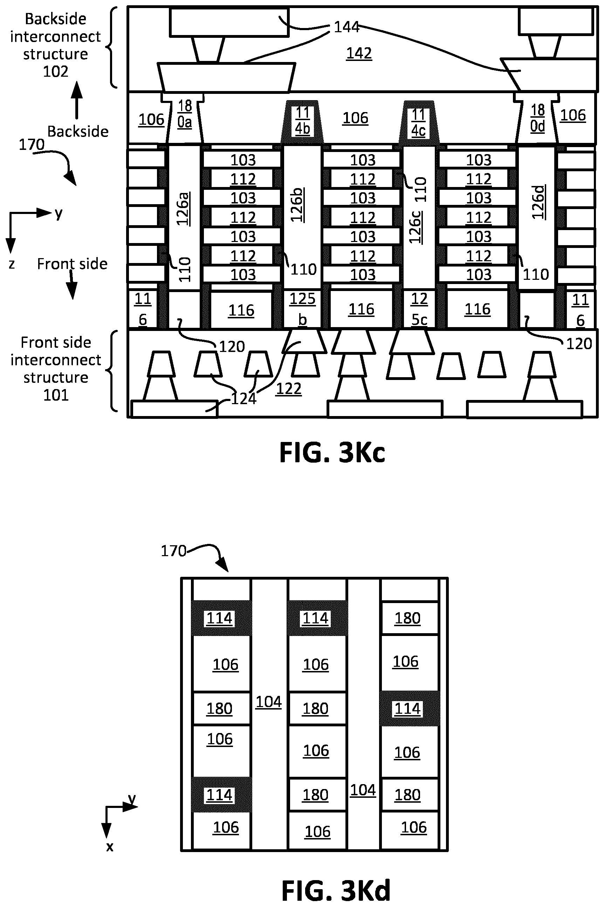

Referring again to the method 200 of Fig. 2, the method 200 proceeds from 240 to 244, formation of the backside interconnect structure 102 is completed using techniques for forming the backside interconnect structure 102 comprising a plurality of interconnect features 144 within one or more layers of dielectric material 142, as illustrated in Figs. 3K1, 3K2, 3K3, and 3K4, and as also illustrated in Figs. 3Ka, 3Kb, 3Kc, and 3Kd. Figs. 3K1, 3K2, and 3K3 are flipped or upside-down version of Figs. 1A, 1B, and 1C, respectively (e.g., as the structure 100 was flipped at process 224 of method 200); and Figs. 3Ka, 3Kb, and 3Kc are flipped or upside-down version of Figs. 1E, 1F, and 1G, respectively.

Note that the processes in method 200 are shown in a particular order for ease of description. However, one or more of the processes may be performed in a different order or may not be performed at all (and thus be optional), in accordance with some embodiments. Numerous variations on method 200 and the techniques described herein will be apparent in light of this disclosure.

### Example System

Fig. 4 illustrates a computing system 1000 implemented with integrated circuit structures formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following examples pertain to further embodiments, from which numerous permutations and configurations will be apparent.

Example 1. An integrated circuit structure, comprising: a device layer comprising a plurality of devices, the plurality of devices including (i) a plurality of source and drain regions, (ii) a plurality of gate stacks, and (iii) a plurality of gate spacers, each gate spacer separating a corresponding source or drain region from a corresponding gate stack, the gate spacers comprising a first dielectric material; a first source or drain contact coupled to a frontside of a first source or drain region of the plurality of source and drain regions; a second dielectric material coupled to a backside of the first source or drain region; and a second source or drain contact coupled to a backside of a second source or drain region of the plurality of source and drain regions; wherein the first dielectric material and the second dielectric material comprise the same elemental constituents.

Example 2. The integrated circuit structure of example 1, wherein a lower surface of the second dielectric material and a lower surface of the second source or drain contact are coplanar with each other within a tolerance of at most 3 nanometers (nm), wherein the lower surfaces of the second dielectric material and the second source or drain contact face a backside interconnect structure.

Example 3. The integrated circuit structure of any one of examples 1-2, further comprising: a third source or drain contact coupled to a frontside of a third source or drain region of the plurality of source and drain regions; and a third dielectric material coupled to a backside of the third source or drain region, wherein lower surfaces of each of the second dielectric material, the second source or drain contact, and the third dielectric material are coplanar within a tolerance of at most 5 nanometers (nm).

Example 4. The integrated circuit structure of any one of examples 1-3, further comprising: a frontside interconnect structure coupled to the first source or drain contact; and a backside interconnect structure coupled to the second source or drain contact.

Example 5. The integrated circuit structure of any one of examples 1-4, wherein a device of the plurality of devices comprises: the first source or drain region, with the first source or drain contact coupled to the frontside of the first source or drain region; the second source or drain region, with the second source or drain contact coupled to the backside of the second source or drain region; and one or more bodies comprising semiconductor material laterally extending from the first source or drain region to the second source or drain region.

Example 6. The integrated circuit structure of example 5, wherein the device of the plurality of devices comprises: a gate stack of the plurality of gate stacks, the gate stack at least partially wrapped around the one or more bodies; and the gate spacers comprising the first dielectric material between the first source or drain region and the gate stack, and wrapped an end portion of each of the one or more bodies.

Example 7. The integrated circuit structure of any one of examples 5-6, wherein each of the bodies comprise one of a nanoribbon, a nanowire, or a nanosheet.

Example 8. The integrated circuit structure of any one of examples 1-7, wherein the second source or drain contact comprises: a stepped sidewall having a first section and a second section, wherein the first section is stepped inward of the second section of the sidewall so as to provide a step section of the stepped sidewall, the step section extending more in the horizontal direction than in the vertical direction.

Example 9. The integrated circuit structure of example 8, wherein: a lower surface of the first section and a lower surface of the second dielectric material are coplanar within a tolerance of at most 3 nanometers (nm), wherein the lower surfaces of the second dielectric material and the second source or drain contact faces a backside interconnect structure.

Example 10. The integrated circuit structure of any one of examples 1-9, wherein: at least a part of a lower surface of the second dielectric material facing a backside of the device layer is at a first horizontal plane; at least a part of a lower surface of the second source or drain contact facing the backside of the device layer is at a second horizontal plane; and the first horizontal plane and the second horizontal plane is separated by a vertical distance of at least 3 nanometers.

Example 11. An integrated circuit structure, comprising: a first source or drain region; a second source or drain region; one or more bodies comprising semiconductor material laterally extending from the first source or drain region to the second source or drain region; a gate electrode at least in part wrapped around the one or more bodies; a spacer comprising a first dielectric material and between the first source region and gate electrode; a source or drain contact coupled to a backside of the first source or drain region; and a second dielectric material coupled to a backside of the second source or drain region; wherein the first dielectric material and the second dielectric material comprise the same elemental constituents.

Example 12. The integrated circuit structure of example 11, wherein the source or drain contact is a first source or drain contact, and wherein the integrated circuit structure further comprises: a second source or drain contact coupled to a frontside of the second source or drain region.

Example 13. The integrated circuit structure of any one of examples 11-12, wherein a lower surface of the second dielectric material and a lower surface of the source or drain contact are coplanar within a tolerance of at most 3 nanometers (nm).

Example 14. The integrated circuit structure of any one of examples 11-13, wherein: at least a part of a lower surface of the second dielectric material facing a backside interconnect structure is at a first horizontal plane; at least a part of a lower surface of the source or drain contact facing the backside interconnect structure is at a second horizontal plane; and the first horizontal plane and the second horizontal plane is separated by a vertical distance of at least 3 nanometers.

Example 15. The integrated circuit structure of any one of examples 11-14, wherein each of the first and second dielectric materials comprises silicon, and one or more of oxygen, nitrogen, and carbon.

Example 16. A method comprising: forming a first source or drain trench and a second source or drain trench, wherein the first and second source or drain trenches extend within respective sub-fin regions, and wherein a first end of a body is exposed through the first source or drain trench, and a second end of the body is exposed through the second source or drain trench, the body comprising a semiconductor material; depositing a first dielectric material within the first source or drain trench, to form (i) a first gate spacer that wraps around the first end of the body, and (ii) a portion of the first dielectric material at a lower section of the first source or drain trench extending within the sub-fin region; depositing a second dielectric material within the second source or drain trench, to form (i) a second gate spacer that wraps around the second end of the body, and (ii) a portion of the second dielectric material at a lower section of the second source or drain trench extending within the sub-fin region; forming a first source or drain region within the first source or drain trench, and above the portion of the first dielectric material; and forming a second source or drain region within the second source or drain trench, and above the portion of the second dielectric material.

Example 17. The method of example 16, further comprising: forming a frontside source or drain contact coupled to the first source or drain region.

Example 18. The method of example 17, further comprising: removing, from a backside of the second source or drain region, the portion of the second dielectric material, to form a recess on the backside of the second source or drain region, without removing the portion of the first dielectric material; and depositing conductive material within the recess, so as to form a backside source or drain contact coupled to the second source or drain region.

Example 19. The method of example 18, wherein removing the portion of the second dielectric material comprises: patterning a mask on the backside of the second source or drain region, the mask having an opening above the portion of the second dielectric material, and the mask covering the portion of the first dielectric material; and removing, through the opening within the mask, the portion of the second dielectric material.

Example 20. The method of any one of examples 17-19, further comprising: forming a frontside interconnect structure coupled to the frontside source or drain contact; and forming a backside interconnect structure coupled to the backside source or drain contact.

The foregoing description of example embodiments of the present disclosure has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto.

## Claims

1. An integrated circuit structure, comprising:
a device layer comprising a plurality of devices, the plurality of devices including (i) a plurality of source and drain regions, (ii) a plurality of gate stacks, and (iii) a plurality of gate spacers, each gate spacer separating a corresponding source or drain region from a corresponding gate stack, the gate spacers comprising a first dielectric material;
a first source or drain contact coupled to a frontside of a first source or drain region of the plurality of source and drain regions;
a second dielectric material coupled to a backside of the first source or drain region; and
a second source or drain contact coupled to a backside of a second source or drain region of the plurality of source and drain regions;
wherein the first dielectric material and the second dielectric material comprise the same elemental constituents.

2. The integrated circuit structure of claim 1, wherein a lower surface of the second dielectric material and a lower surface of the second source or drain contact are coplanar with each other within a tolerance of at most 3 nanometers (nm), wherein the lower surfaces of the second dielectric material and the second source or drain contact face a backside interconnect structure.

3. The integrated circuit structure of claim 1 or 2, further comprising:
a third source or drain contact coupled to a frontside of a third source or drain region of the plurality of source and drain regions; and
a third dielectric material coupled to a backside of the third source or drain region,
wherein lower surfaces of each of the second dielectric material, the second source or drain contact, and the third dielectric material are coplanar within a tolerance of at most 5 nanometers (nm).

4. The integrated circuit structure of any one of claims 1 through 3, further comprising:
a frontside interconnect structure coupled to the first source or drain contact; and
a backside interconnect structure coupled to the second source or drain contact.

5. The integrated circuit structure of any one of claims 1 through 4, wherein a device of the plurality of devices comprises:
the first source or drain region, with the first source or drain contact coupled to the frontside of the first source or drain region;
the second source or drain region, with the second source or drain contact coupled to the backside of the second source or drain region; and
one or more bodies comprising semiconductor material laterally extending from the first source or drain region to the second source or drain region.

6. The integrated circuit structure of claim 5, wherein the device of the plurality of devices comprises:
a gate stack of the plurality of gate stacks, the gate stack at least partially wrapped around the one or more bodies; and
the gate spacers comprising the first dielectric material between the first source or drain region and the gate stack, and wrapped an end portion of each of the one or more bodies.

7. The integrated circuit structure of claim 5 or 6, wherein each of the bodies comprise one of a nanoribbon, a nanowire, or a nanosheet.

8. The integrated circuit structure of any one of claims 1 through 7, wherein the second source or drain contact comprises:
a stepped sidewall having a first section and a second section, wherein the first section is stepped inward of the second section of the sidewall so as to provide a step section of the stepped sidewall, the step section extending more in the horizontal direction than in the vertical direction.

9. The integrated circuit structure of claim 8, wherein:
a lower surface of the first section and a lower surface of the second dielectric material are coplanar within a tolerance of at most 3 nanometers (nm), wherein the lower surfaces of the second dielectric material and the second source or drain contact faces a backside interconnect structure.

10. The integrated circuit structure of any one of claims 1 through 9, wherein:
at least a part of a lower surface of the second dielectric material facing a backside of the device layer is at a first horizontal plane;
at least a part of a lower surface of the second source or drain contact facing the backside of the device layer is at a second horizontal plane; and
the first horizontal plane and the second horizontal plane is separated by a vertical distance of at least 3 nanometers.

11. A method comprising:
forming a first source or drain trench and a second source or drain trench, wherein the first and second source or drain trenches extend within respective sub-fin regions, and wherein a first end of a body is exposed through the first source or drain trench, and a second end of the body is exposed through the second source or drain trench, the body comprising a semiconductor material;
depositing a first dielectric material within the first source or drain trench, to form (i) a first gate spacer that wraps around the first end of the body, and (ii) a portion of the first dielectric material at a lower section of the first source or drain trench extending within the sub-fin region;
depositing a second dielectric material within the second source or drain trench, to form (i) a second gate spacer that wraps around the second end of the body, and (ii) a portion of the second dielectric material at a lower section of the second source or drain trench extending within the sub-fin region;
forming a first source or drain region within the first source or drain trench, and above the portion of the first dielectric material; and
forming a second source or drain region within the second source or drain trench, and above the portion of the second dielectric material.

12. The method of claim 11, further comprising:
forming a frontside source or drain contact coupled to the first source or drain region.

13. The method of claim 12, further comprising:
removing, from a backside of the second source or drain region, the portion of the second dielectric material, to form a recess on the backside of the second source or drain region, without removing the portion of the first dielectric material; and
depositing conductive material within the recess, so as to form a backside source or drain contact coupled to the second source or drain region.

14. The method of claim 13, wherein removing the portion of the second dielectric material comprises:
patterning a mask on the backside of the second source or drain region, the mask having an opening above the portion of the second dielectric material, and the mask covering the portion of the first dielectric material; and
removing, through the opening within the mask, the portion of the second dielectric material.

15. The method of any one of claims 12 through 14, further comprising:
forming a frontside interconnect structure coupled to the frontside source or drain contact; and
forming a backside interconnect structure coupled to the backside source or drain contact.
